# EUROPEAN PATENT APPLICATION

(11) **EP 2 660 966 A1**
(43) Date of publication of application: **06.11.2013**
(21) Application number: 11852791.0
(22) Date of filing: 07.12.2011
(51) Int. Cl.: H02M 7/48, B60K 6/48, B60K 6/54, B60K 6/28, B60K 11/06, B60L 11/14

(54) **POWER CONVERSION APPARATUS FOR VEHICLE**

(30) Priority: 27.12.2010 JP 2010289096
(71) Applicant: Hitachi Automotive Systems, Ltd., Hitachinaka-shi Ibaraki 312-8503 (JP)
(72) Inventor: NISHIKIMI, Fusanori, Hitachinaka-shi Ibaraki 312-8503 (JP); KUMAGAI, Masato, Hitachinaka-shi Ibaraki 312-8503 (JP); ISHII, Akira, Hitachinaka-shi Ibaraki 312-8503 (JP)
(74) Representative: MERH-IP Matias Erny Reichl Hoffmann
(86) International application number: PCT/JP2011/078331
(87) International publication number: WO 2012/090667

(57) **Abstract**

A first power semiconductor module and a second power semiconductor module are fixed in parallel to a first channel along a flow direction of a cooling refrigerant flowing through the first channel, a third power semiconductor module is fixed to a second channel such that the first power semiconductor module and the third power semiconductor module face each other via a capacitor circuit unit, and an electric circuit element electrically connected in series or in parallel with regard to the capacitor circuit unit and a DC terminal is arranged in such a position that the second power semiconductor module and the electric circuit element face each other via the capacitor circuit unit.

## Description

### Technical Field

The present invention relates to a power conversion apparatus used to convert DC power to AC power or to convert AC power to DC power.

### Background Art

In general, a power conversion apparatus includes a smoothing capacitor module configured to receive DC power from a DC power source, an inverter circuit configured to receive DC power from the capacitor module and generate AC power, and a control circuit for controlling the inverter circuit. The AC power is supplied to a motor, for example, and the motor generates rotation torque according to the supplied AC power. The motor generally has a function as a generator and, when supplied with mechanical energy from the outside, the motor generates AC power based on the supplied mechanical energy. The power conversion apparatus also has a function for converting AC power to DC power in many cases, and AC power generated by the motor is converted into DC power. Conversion from DC power to AC power or conversion from AC power to DC power is controlled by the control apparatus. For example, when the motor is a synchronous motor, it is possible to perform control regarding the power conversion by controlling the phase of a rotating magnetic field generated by the stator with regard to the magnetic pole position of the rotor of the synchronous motor. An example of the power conversion apparatus is disclosed in PTL 1.

A power conversion apparatus is mounted on an automobile, for example, to receive DC power from a secondary cell mounted on the same automobile and generate AC power to be supplied to a motor configured to generate rotation torque for traveling. Furthermore, in order to generate braking force during regenerative braking running of the automobile, the motor generates AC power based on traveling energy, and the generated AC power is converted into DC power by the power conversion apparatus, stored in the secondary cell, and later used as power for vehicle traveling and the like.

### Citation List

### Patent Literature

PTL 1: Japanese Patent Application Laid-Open No. 2009-219270

### Summary of Invention

### Technical Problem

A power conversion apparatus has a plurality of electric components inside it. Since compactness of power conversion apparatuses is sought, the ratio of integration of electric components inside power conversion apparatuses tends to increase. This poses a problem in that the electric components may be influenced by heat resulting from either heat transfer among the electric components or heat transfer from outside the power conversion apparatus or from a combination of them.

An object of the present invention is to provide a power conversion apparatus having reduced influence of heat resulting from compactness of the power conversion apparatus.

### Solution to Problem

According to a first aspect of the present invention, a vehicular power conversion apparatus includes: a capacitor circuit unit configured to smooth a DC current supplied from a DC power source; a channel forming body configured to form a channel through which a cooling refrigerant flows; a power semiconductor module having a power semiconductor element configured to convert a DC current output from the capacitor circuit unit into an AC current and supply the AC current to a vehicle driving motor; a housing configured to contain the capacitor circuit unit, the channel forming body, and the power semiconductor module; a DC terminal provided on a surface of the housing; and an electric circuit element electrically connected in series or in parallel with regard to the capacitor circuit unit and the DC terminal, wherein the channel forming body forms a first channel and a second channel, the first channel and the second channel are arranged in parallel with each other while interposing the capacitor circuit unit, the power semiconductor module has a first power semiconductor module configured to output a first-phase AC current, a second power semiconductor module configured to output a second-phase AC current, and a third power semiconductor module configured to output a third-phase AC current, the first power semiconductor module and the second power semiconductor module are fixed in parallel to the first channel along a flow direction of a cooling refrigerant flowing through the first channel, the third power semiconductor module is fixed to the second channel such that the first power semiconductor module and the third power semiconductor module face each other via the capacitor circuit unit, and the electric circuit element is arranged in such a position that the second power semiconductor module and the electric circuit element face each other via the capacitor circuit unit.
According to a second aspect of the present invention, in the vehicular power conversion apparatus according to the first aspect, the electric circuit element is preferably a noise removing capacitor element having an electrode on one side electrically connected to the DC terminal and an electrode on the other side electrically connected to ground of a vehicle body.
According to a third aspect of the present invention, in the vehicular power conversion apparatus according to the second aspect, the DC terminal is preferably arranged in a position closer to the noise removing capacitor element than the first power semiconductor module, the second power semiconductor module, and the third power semiconductor module.
According to a fourth aspect of the present invention, the vehicular power conversion apparatus according to the second aspect further includes: a capacitor case containing the capacitor circuit unit and the noise removing capacitor element; and a resin sealing material sealing the capacitor circuit unit and the noise removing capacitor element in the capacitor case, wherein the capacitor circuit unit and the noise removing capacitor element are film capacitors.
According to a fifth aspect of the present invention, the vehicular power conversion apparatus according to the first aspect further preferably includes a discharging resistor electrically connected to the capacitor circuit unit, wherein the discharging resistor is arranged on an opposite side to the capacitor circuit unit via the second channel.
According to a sixth aspect of the present invention, in the vehicular power conversion apparatus according to the first aspect, the capacitor circuit unit preferably has a first DC terminal connected to the DC terminal via wiring, the housing has an opening formed at a part facing the first DC terminal, and the opening of the housing is covered by a cover.
According to a seventh aspect of the present invention, the vehicular power conversion apparatus according to any one of the first to sixth aspects further preferably includes: a DC busbar configured to supply the DC current to the power semiconductor module; an AC busbar configured to supply the AC current to the driving motor; and an AC terminal provided on the surface of the housing, on which the DC terminal is provided, wherein a formation direction of the DC busbar towards an interior of the housing from the DC terminal is formed along a formation direction of the AC busbar towards an interior of the case from the AC terminal.

### Advantageous Effects of Invention

According to the present invention, it is possible to reduce influence of heat resulting from compactness of the power conversion apparatus.

### Brief Description of Drawings

[FIG. 1] FIG. 1 is a system diagram illustrating a system of a hybrid automobile.
[FIG. 2] FIG. 2 is a circuit diagram illustrating a configuration of an electric circuit illustrated in FIG. 1.
[FIG. 3] FIG. 3 is an external perspective view of a power conversion apparatus 200.
[FIG. 4] FIG. 4 is an exploded perspective view of the power conversion apparatus 200.
[FIG. 5] FIG. 5 is a diagram of a case 10, seen from below, illustrated in FIG. 4.
[FIG. 6] FIG. 6A is a perspective view of a power semiconductor module 300a according to the present embodiment. FIG. 6B is a sectional view of the power semiconductor module 300a according to the present embodiment taken along section D and seen from direction E.
[FIG. 7] FIG. 7 is a diagram illustrating the power semiconductor module 300a after removing screws 309 and second sealing resin 351 from the state illustrated in FIG. 6, FIG. 7A is a perspective view, and FIG. 7B is a sectional view taken along section D and seen from direction E as in the case of FIG. 6B.
[FIG. 8] FIG. 8 is a diagram illustrating the power semiconductor module 300a after further removing a module case 304 from the state illustrated in FIG. 7, FIG. 8A is a perspective view, and FIG. 8B is a sectional view taken along section D and seen from direction E as in the case of FIG. 6B and FIG. 7B.
[FIG. 9] FIG. 9 is a perspective view of the power semiconductor module 300a after further removing first sealing resin 348 and a wiring insulation portion 608 from the state illustrated in FIG. 8.
[FIG. 10] FIG. 10 is a diagram illustrating a process of assembling a module primary sealing body 302.
[FIG. 11] FIG. 11 is a perspective view illustrating a structure of a capacitor module 500.
[FIG. 12] FIG. 12A is an external perspective view when power semiconductor modules 300a to 300c, a capacitor module 500, and a busbar assembly 800 are fitted together to the case 10, and FIG. 12B is a magnified view of part A of FIG. 12A.
[FIG. 13] FIG. 13 is an exploded perspective view of the case 10, to which the power semiconductor modules 300a to 300c and the capacitor module 500 are fitted together, and the busbar assembly 800.
[FIG. 14] FIG. 14 is an external perspective view of the busbar assembly 800 after removing a retaining member 803.
[FIG. 15] FIG. 15 is a perspective view of the power conversion apparatus 200 with a metal base plate 11 separated.
[FIG. 16] FIG. 16 is a sectional view of the power conversion apparatus 200 seen from the direction of the arrow of section B of FIG. 15.
[FIG. 17] FIG. 17 is a magnified view of peripheral parts of AC terminals 822a to 822c.
[FIG. 18] FIG. 18 is a magnified view of peripheral parts of a negative electrode-side DC terminal 900a and a positive electrode-side DC terminal 900b.
[FIG. 19] FIG. 19 is an exploded perspective view of the case 10, to which AC terminals 822a to 822c and DC terminals 900a and 900b are fitted together, and a vehicle-side connector 193.
[FIG. 20] FIG. 20 is a side view of the case 10 seen from a side on which the AC terminals 822a to 822c and the DC terminal 900a are arranged.
[FIG. 21] FIG. 21 is a top view of a capacitor module 500 from which a resin sealing material 550 is removed.
[FIG. 22] FIG. 22 is a top view of the power conversion apparatus 200 from which electric parts arranged above the capacitor module 500 illustrated in FIG. 4 are removed.
[FIG. 23] FIG. 23 is a sectional view seen from the direction of the arrows of dashed line AA of FIG. 22.
[FIG. 24] FIG. 24 is a sectional view seen from the direction of the arrows of dashed line BB of FIG. 22.

### Description of Embodiments

A power conversion apparatus described in the following embodiments to which the present invention is applied, as well as a system using the apparatus, solves various problems that are needed to be solved for commercial production. One of the various problems solved by these embodiments is a problem regarding influence of heat resulting from compactness of the power conversion apparatus, which is described above in the section of Technical Problem. Furthermore, various problems other than the above-described problems and effects are solved, making it possible to achieve various effects.

For example, in connection with a problem of improving resistance to vibration, not only the configuration described above in the section of Technical Problem, but other configurations can also solve the problem.

In other words, in connection with the problem of improving resistance to vibration and relevant effects, configurations other than the above-described configuration solve, though largely concerned with problem solving and effect achieving related to improving resistance to vibration, the problem from a different point of view, to be more specific, and obtains relevant effects.

In the case of a power conversion apparatus including a case, which contains a power semiconductor module configured to convert DC power to AC power, and a connector to which a DC-side connector and an AC-side connector are mechanically coupled, and which is fixed to the case, a positive electrode-side DC terminal and a negative electrode-side DC terminal are arranged in parallel along a short-direction side of a side surface of the case, and a U phase-side terminal, a V phase-side terminal, and a W phase-side terminal are arranged in parallel along a longitudinal-direction side of a side surface of the case. This configuration suppresses deviation of insertion stress of the connector, making it possible to improve resistance to vibration of the positive electrode-side DC terminal, the negative electrode-side DC terminal, and the AC terminal.

Another configuration for solving a problem of having to further improve resistance to vibration will be described briefly. This configuration includes a support member supporting an AC terminal and a case forming an opening; the case further includes a wall protruding from an edge of the opening toward the outside of the case; the support member covers the first opening from the inner wall side of the case; and AC wiring connected to the motor side extends through a space surrounded by the wall, and is connected to the AC terminal supported on the support member. According to this configuration, the support member makes a contact to such an extent that it covers the opening of the case, and the AC wiring is supported by the wall protruding from the case, making it possible to make the resonance frequency of the AC terminal and the AC wiring higher than the frequency of vibration transmitted from the engine and the like.

Meanwhile, an embodiment for solving the problem of compactness using a vehicular power conversion apparatus according to the present invention will now be described. The vehicular power conversion apparatus according to the present invention includes a capacitor circuit unit configured to smooth a DC current; a channel forming body configured to form a channel through which a cooling refrigerant flows; a power semiconductor module configured to receive a DC current output from the capacitor circuit unit and supply a three-phase AC current to a motor; a case configured to contain the capacitor circuit unit, the channel forming body, and the power semiconductor module; and an electric circuit element connected electrically in series or in parallel with regard to the capacitor circuit unit and the DC terminal. The channel forming body forms a first channel and a second channel, and the first channel and the second channel are arranged in parallel with each other while interposing the capacitor circuit unit. The power semiconductor module includes a first power semiconductor module configured to output a first phase AC current, a second power semiconductor module configured to output a second phase AC current, and a third power semiconductor module configured to output a third phase AC current. The first power semiconductor module and the second power semiconductor module are fixed in parallel with the first channel along a flow direction of a cooling refrigerant flowing through the first channel. The third power semiconductor module is fixed to the second channel so as to face the first power semiconductor module via the capacitor circuit unit. The electric circuit element is arranged in a position facing the second power semiconductor module via the capacitor circuit unit. This configuration guarantees that, even when two of the power semiconductor modules, which are provided for respective phases, are arranged on one side surface of the capacitor circuit unit and one of them is arranged on the other side surface, the power semiconductor modules and the capacitor circuit unit are configured in an orderly manner, and the cooling performance of the cooling refrigerant can be fully exhibited.

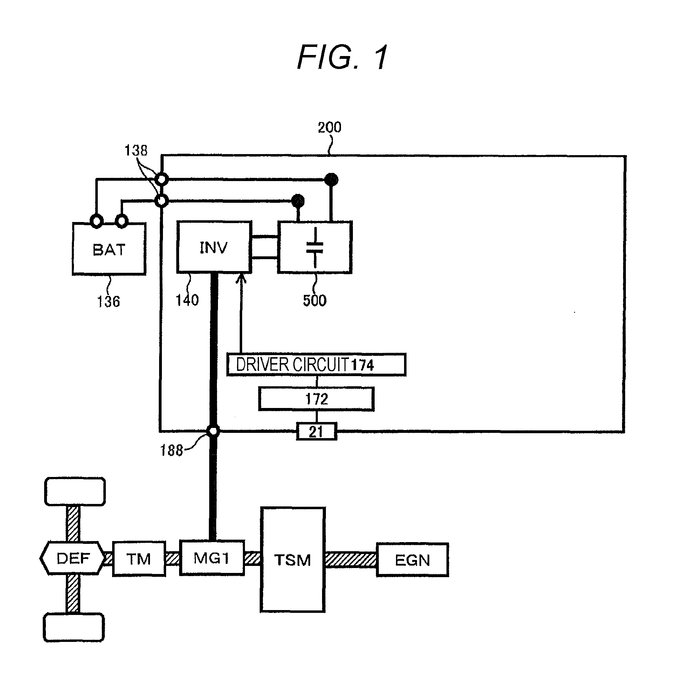

Hereinafter, an embodiment for practicing the present invention will be described with reference to the drawings. FIG. 1 is a diagram illustrating a control block of a hybrid automobile (hereinafter, referred to as HEV). An engine EGN and a motor generator MG1 generate torque for vehicle traveling. Furthermore, the motor generator MG1 does not only generate rotation torque, but also has a function of converting mechanical energy, which is applied to the motor generator MG1 from the outside, into power.

The motor generator MG1 is a synchronous motor or an induction motor, for example, and operates either as a motor or as a generator according to the running method, as described above. When the motor generator MG1 is mounted on an automobile, it is desired to obtain high output using a compact size, and therefore a permanent magnet-type synchronous motor using a magnet of neodymium, for example, is suitable. Furthermore, the permanent magnet-type synchronous motor, compared with an induction motor, has less heat generated by the rotor, and is an excellent choice for an automobile from this point of view as well.

Output torque of the output side of the engine EGN is transmitted to the motor generator MG1 via a power distribution mechanism TSM, and rotation torque from the power distribution mechanism TSM or rotation torque generated by the motor generator MG1 is transmitted to wheels via a transmission TM and a differential gear DEF. Meanwhile, during regenerative braking running, rotation torque is transmitted from the wheels to the motor generator MG1, and AC power is generated based on the supplied rotation torque. The generated AC power is converted into DC power by the power conversion apparatus 200, as will be described later, and charges a high-voltage battery 136, and the charged power is used later as traveling energy.

Next, the power conversion apparatus 200 will be described. An inverter circuit 140 is electrically connected to the battery 136 via a DC-side connector 138, so that the battery 136 and the inverter circuit 140 exchange power with each other. When the motor generator MG1 is operated as a motor, the inverter circuit 140 generates AC power based on DC power supplied from the battery 136 via the DC-side connector 138, and supplies the generated AC power to the motor generator MG1 via an AC connector 188. The configuration consisting of the motor generator MG1 and the inverter circuit 140 operates as a first electromechanical generating unit.

Also, according to the present embodiment, by operating the first electromechanical generating unit as an electromechanical unit by means of power of the battery 136, it is possible to drive the vehicle by means of power of the motor generator MG1 alone. Furthermore, according to the present embodiment, by operating the first electromechanical generating unit as a generating unit by means of power of the engine EGN or power from the wheels so that it generates power, it is possible to charge the battery 136.

Also, the power conversion apparatus 200 includes a capacitor module 500 for smoothing DC power supplied to the inverter circuit 140.

The power conversion apparatus 200 includes a communication connector 21 for receiving a command from a superior control apparatus or sending data, which indicates the state, to the superior control apparatus. The power conversion apparatus 200 calculates a control amount of the motor generator MG1 using a control circuit 172 based on a command input from the connector 21, further calculates whether to run as a motor or to run as a generator, generates a control pulse based on the calculation result, and supplies the control pulse to a driver circuit 174. The driver circuit 174 generates a driving pulse for controlling the inverter circuit 140 based on the supplied control pulse.

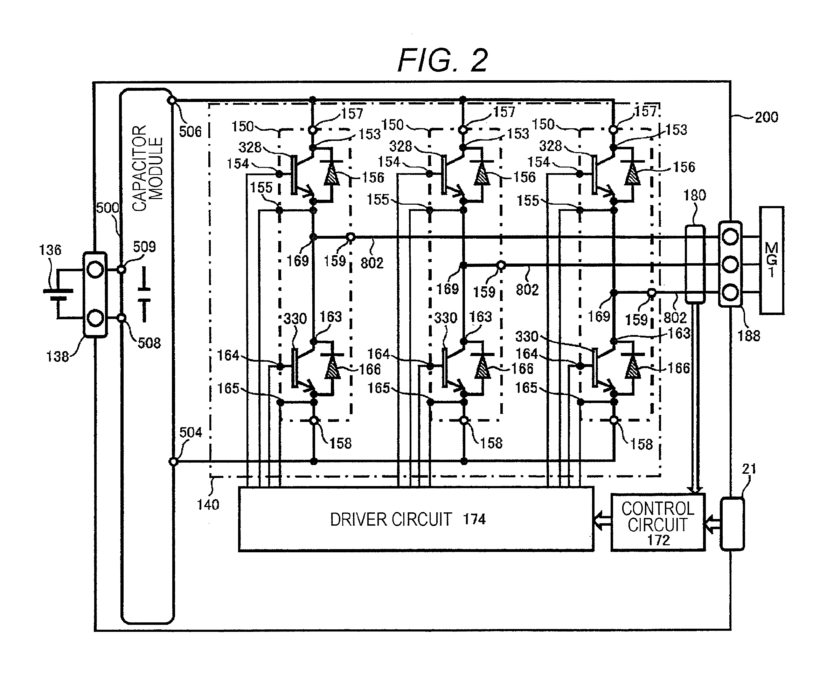

Next, a configuration of an electric circuit of the inverter circuit 140 will be described with reference to FIG. 2. Also, insulated-gate bipolar transistors will hereinafter be used as semiconductor elements, and will simply be referred to as IGBTs. An IGBT 328 and a diode 156, which operate as an upper arm, and an IGBT 330 and a diode 166, which operate as a lower arm, constitute a series circuit 150 of upper and lower arms. The inverter circuit 140 includes series circuits 150 corresponding to three phases of U phase, V phase, and W phase of AC power, which is to be output.

The three phases correspond to respective phase coils of three phases of armature coils of the motor generator MG1. Each of the series circuits 150 of upper and lower arms of three phases output an AC current from an intermediate electrode 169, which is the center point part of the series circuit. The intermediate electrode 169 is connected with AC busbars 802 and 804 (described later), which are AC power lines to the motor generator MG1, through an AC terminal 159 and an AC terminal 188.

Collector electrodes 153 of the IGBTs 328 of the upper arms are electrically connected to a positive electrode-side capacitor terminal 506 of the capacitor module 500 via a positive pole terminal 157. Furthermore, emitter electrodes of the IGBTs 330 of the lower arms are electrically connected to a negative electrode-side capacitor terminal 504 of the capacitor module 500 via a negative pole terminal 158.

As described above, the control circuit 172 receives a control command from the superior control apparatus via the connector 21, generates a control pulse, which is a control signal for controlling the IGBTs 328 or the IGBTs 330 constituting the upper arms or the lower arms of the series circuits 150 of respective phases constituting the inverter circuit 140, based on the control command, and supplies the control pulse to the driver circuit 174.

The driver circuit 174 supplies a driving pulse for controlling the IGBTs 328 or the IGBTs 330 constituting the upper arms or the lower arms of the series circuits 150 of respective phases, based on the control pulse, to the IGBTs 328 or the IGBTs 330 of respective phases. The IGBTs 328 or the IGBTs 330 perform a conducting or interrupting operation, based on the driving pulse from the driver circuit 174, and convert DC power supplied from the battery 136 into three-phase AC power, and the converted power is supplied to the motor generator MG1.

Each IGBT 328 includes a collector electrode 153, a signaling emitter electrode 155, and a gate electrode 154. Furthermore, each IGBT 330 includes a collector electrode 163, a signaling emitter electrode 165, and a gate electrode 164. A diode 156 is electrically connected between the collector electrode 153 and the emitter electrode 155. Furthermore, a diode 166 is electrically connected between the collector electrode 163 and the emitter electrode 165.

As the switching power semiconductor elements, metal-oxide-semiconductor field-effect transistors (hereinafter, simply referred to as MOSFETs) may be used, and the diodes 156 and the diodes 166 are unnecessary in this case. As the switching power semiconductor elements, the IGBTs are suitable for a case of a relatively high DC voltage, while the MOSFETs are suitable for a case of a relatively low DC voltage.

The capacitor module 500 includes a positive electrode-side capacitor terminal 506, a negative electrode-side capacitor terminal 504, a positive electrode-side power source terminal 509, and a negative electrode-side power source terminal 508. High-voltage DC power from the battery 136 is supplied to the positive electrode-side power source terminal 509 and the negative electrode-side power source terminal 508 via the DC-side connector 138, and is supplied from the positive electrode-side capacitor terminal 506 and the negative electrode-side capacitor terminal 504 of the capacitor module 500 to the inverter circuit 140.

Meanwhile, DC power converted from AC power by the inverter circuit 140 is supplied from the positive electrode-side capacitor terminal 506 and the negative electrode-side capacitor terminal 504 to the capacitor module 500, is supplied from the positive electrode-side power source terminal 509 and the negative electrode-side power source terminal 508 to the battery 136 via the DC-side connector 138, and is accumulated in the battery 136.

The control circuit 172 includes a microcomputer (hereinafter, referred to as a micom) for calculating/processing the switching timing of the IGBTs 328 and the IGBTs 330. Input information to the micom includes a target torque value required with regard to the motor generator MG1, a current value supplied from the series circuits 150 to the motor generator MG1, and a magnetic pole position of the rotor of the motor generator MG1.

The target torque value is based on a command signal output from the superior command apparatus (not illustrated). The current value is detected based on a detection signal obtained by a current sensor 180. The magnetic pole position is detected based on a detection signal output from a rotating magnetic pole sensor (not illustrated), such as a resolver, provided on the motor generator MG1. Although it is assumed in the present embodiment that the current sensor 180 detects a three-phase current value, it is also possible to detect a current value for two phases and acquire a current for three phases by calculation.

The micom inside the control circuit 172 calculates current command values of d-axis and q-axis of the motor generator MG1 based on the target torque value, calculates voltage command values of d-axis and q-axis based on differences between the calculated current command values of d-axis and q-axis and detected current values of d-axis and q-axis, and converts the calculated voltage command values of d-axis and q-axis into voltage command values of U phase, V phase, and W phase based on the detected magnetic pole position. The micom then generates a pulsed modulation wave based on a comparison between a fundamental wave (sine wave) and a carrier wave (triangular wave), which is based on the voltage command values of U phase, V phase, and W phase, and outputs the generated modulation wave as a PWM (pulse width modulation) signal to the driver circuit 174.

The driver circuit 174, when driving a lower arm, outputs a drive signal, which is obtained by amplifying the PWM signal, to the gate electrode of the IGBT 330 of the corresponding lower arm. Furthermore, the driver circuit 174, when driving upper arms, amplifies the PWM signal by shifting the level of reference potential of the PWM signal to the level of reference potential of the upper arms, and outputs the amplified PWM signal, as a drive signal, to the gate electrodes of the IGBTs 328 of the corresponding upper arms, respectively.

Furthermore, the micom inside the control circuit 172 performs abnormality sensing (overcurrent, overvoltage, over-temperature, and the like) to protect the series circuits 150. To this end, sensing information is input to the control circuit 172. For example, from the signaling emitter electrode 155 and the signaling emitter electrode 165 of each arm, information regarding the current flowing through the emitter electrode of each IGBT 328 and IGBT 330 is input to a corresponding driving unit (IC). By means of this, each driving unit (IC) performs overcurrent sensing and, when an overcurrent is sensed, stops the switching operation of the corresponding IGBT 328 and IGBT 330 and protects the corresponding IGBT 328 and IGBT 330 from the overcurrent.

From temperature sensors (not illustrated) provided on the series circuits 150, information regarding the temperature of the series circuits 150 is input to the micom. Furthermore, information regarding the DC positive electrode-side voltage of the series circuits 150 is input to the micom. The micom performs over-temperature sensing and overvoltage sensing based on such information and, when an over-temperature or an overvoltage is sensed, stops the switching operation of all IGBTs 328 and IGBTs 330.

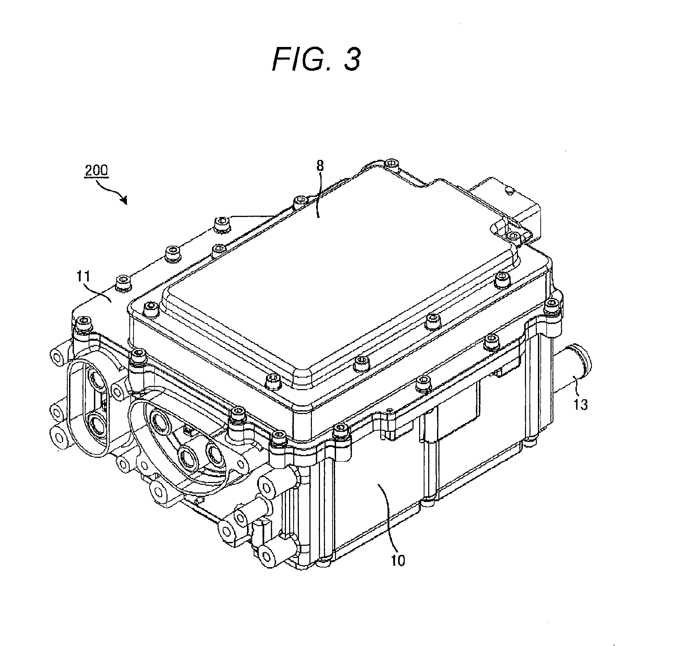

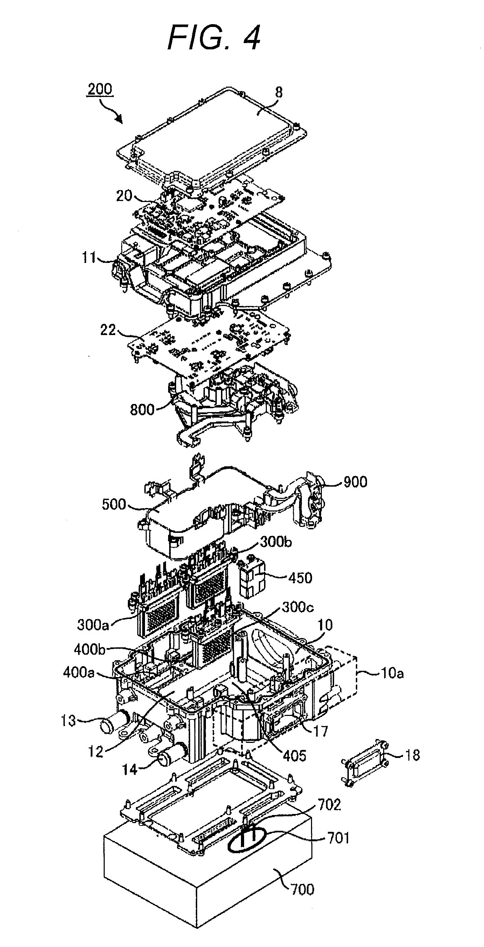

FIG. 3 is an external perspective view of the power conversion apparatus 200. FIG. 4 is a perspective view of the power conversion apparatus 200, which is disassembled to illustrate the internal configuration of the case 10 of the power conversion apparatus 200 and thus aid understanding.

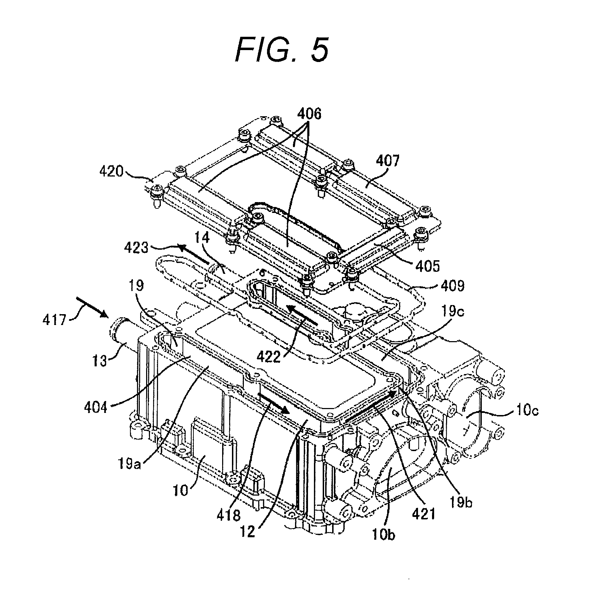

Inlet piping 13 for flow-in of a refrigerant and outlet piping 14 for flow-out of the refrigerant are arranged on the same side surface of the case 10. The case 10 contains a channel forming body 12 so that a refrigerant channel 19 illustrated in FIG. 5 extends along both sides of the case 10. On an upper surface of one side of the channel forming body 12, an opening 400a and an opening 400b are formed along a side surface of the case 10, and, on an upper surface of the other side of the channel forming body 12, an opening 400c is formed. The openings 400a to 400c are covered by inserted power semiconductor modules 300a to 300c.

Between a first channel portion 19a on one side and a second channel portion 19c on the other side, the portions are formed by the channel forming body 12, a containing space 405 for containing a capacitor module 500 is formed, so that the capacitor module 500 is contained in the containing space 405. As a result of this, the capacitor module 500 is cooled by the refrigerant flowing inside the refrigerant channel 19. The capacitor module 500 is, as illustrated in FIG. 5, arranged so as to be surrounded by the refrigerant channels 19a to 19c, enabling it to be cooled efficiently.

Furthermore, since the channel is formed along the outer surface of the capacitor module 500, the channel, the capacitor module 500, and the power semiconductor module 300 are arranged in an orderly manner, making the entire configuration more compact. Furthermore, the refrigerant channels 19a and 19c are arranged along the longer side of the capacitor module 500, so that the distance between power semiconductor modules 300 and 301, which are inserted and fixed into the refrigerant channel 19, becomes approximately constant. This makes it easy to balance the circuit constant of the smoothing capacitor and the power semiconductor module circuit with regard to each phase of the three phases, and the spike voltage can be reduced easily in the resulting circuit configuration. In the present embodiment, water is most preferred as the refrigerant. However, other refrigerants than water can also be used, and will hereinafter be referred to as a refrigerant as a whole.

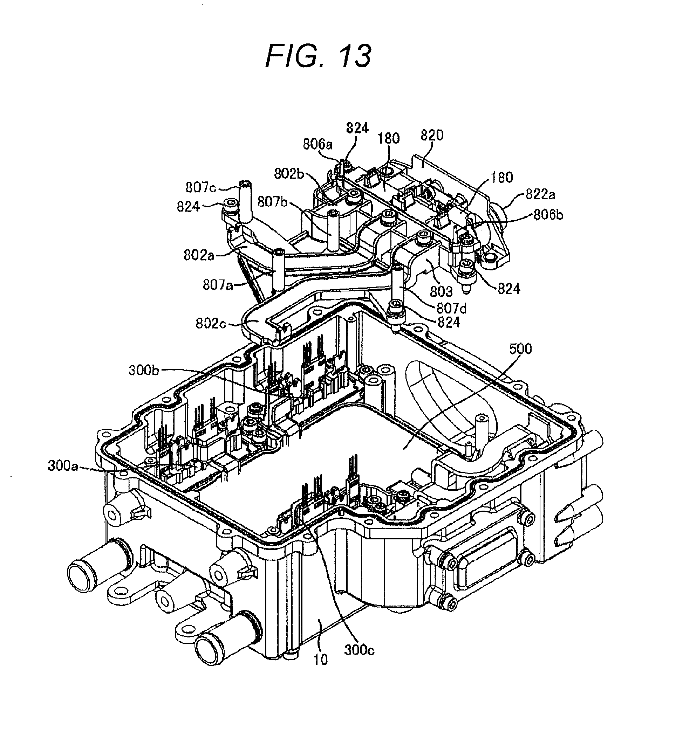

A busbar assembly 800 (described later) is arranged above the capacitor module 500. The busbar assembly 800 includes an AC busbar 186 and a retaining member 803 (refer to FIG. 13) configured to retain the AC busbar 186, and thereby retains current sensors 180.

When the channel forming body 12 and the case 10 are fabricated as an integral unit through casting of aluminum material, the refrigerant channel 19 has, besides a cooling effect, an effect of enhancing mechanical strength. Furthermore, when the channel forming body 12 and the case 10 are integrally casted through aluminum casting, heat conduction of the entire power conversion apparatus 200 becomes better, improving the cooling efficiency.

A driver circuit board 22 is arranged above the busbar assembly 800. Furthermore, a metal base plate 11 is arranged between the driver circuit board 22 and a control circuit board 20.

The metal base plate 11 is fixed to the case 10. The metal base plate 11 exhibits a function of an electromagnetic shield of a group of circuits mounted on the driver circuit board 22 and the control circuit board 20, and also has a function of releasing heat generated by the driver circuit board 22 and the control circuit board 20 and thus cooling them. The metal base plate 11 has a high noise suppression function, which will be described later.

The metal base plate 11 also exhibits a function of raising the mechanical resonance frequency of the control circuit board 20. In other words, it becomes possible to arrange, at a short interval, screw stoppers for fixing the control circuit board 20 to the metal base plate 11, making it possible to shorten the distance between support points, when mechanical vibration has occurred, and to raise the resonance frequency. Since the resonance frequency of the control circuit board 20 can be made high with regard to a vibration frequency transmitted from the engine and the like, the vibration becomes hardly influential, and the reliability improves.

A cover 8 is fixed to the metal base plate 11 to protect the control circuit board 20 from external electromagnetic noise.

The case 10 according to the present embodiment approximately has the shape of a rectangular parallelepiped, in connection with its part that contains the channel forming body 12, but a protruding containing portion 10a is formed from a side surface of the case 10. The protruding containing portion 10a contains a terminal 702 extending from a DC/DC converter 700, a DC-side busbar assembly 800 (described later), and a resistor 450. In this case, the resistor 450 is a resistance element for discharging a charge accumulated in capacitor elements of the capacitor module 500. Because electric circuit parts between the battery 136 and the capacitor module 500 are aggregated in the protruding containing portion 10a in this manner, it becomes possible to prevent wiring from being complicated and to contribute to compactness of the entire apparatus.

Also, a cover 18 is a member for covering a working window 17 for connecting the terminal 702 extending from the DC/DC converter 700. Also, the DC/DC converter 700 has an opening 701 formed on a surface, which faces the bottom surface of the case 10, so that the terminal 702 extends through the opening 701.

According to this configuration, the channel forming body 12 is arranged on the bottom portion of the power conversion apparatus 200, and necessary parts such as the capacitor module 500, the busbar assembly 800, and boards are then fixed from above one after another, thereby improving productivity and reliability.

FIG. 5 is a diagram illustrating the case 10 and the channel forming body 12, wherein the case 10 illustrated in FIG. 4 is seen from below.

On the lower surface of the case 10, an opening 404 is formed as an interlinked one, and the opening 404 is covered by a lower cover 420. A seal member 409 is provided between the lower cover 420 and the case 10 to maintain air tightness.

The lower cover 420 has convex portions 406 protruding toward a direction of the opposite side to the side on which the refrigerant channel 19 is arranged. The convex portions 406 are provided so as to correspond to the power semiconductor modules 300a to 300c. Also, a convex portion 407, although it does not correspond to any power semiconductor module, is provided to adjust the sectional area of the refrigerant channel 19.

The refrigerant passes through the inlet piping 13 in a flow direction 417 indicated by a dotted line and flows inside the first channel portion 19a, which is formed along a longitudinal-direction side of the case 10, along a flow direction 418. Furthermore, the refrigerant, as indicated by a flow direction 421, flows through a second channel portion 19b, which is formed along a short-direction side of the case 10, along the flow direction 421. The second channel portion 19b forms a folding-back channel. Furthermore, the refrigerant flows through a third channel portion 19c, which is formed along the longitudinal-direction side of the channel forming body 12, along a flow direction 422. The third channel portion 19c is provided in a position facing the first channel portion 19a while interposing the capacitor module 500. Furthermore, the refrigerant flows out through the outlet piping 14 along a flow direction 423.

Any of the first channel portion 19a, the second channel portion 19b, and the third channel portion 19c is formed so that the depth direction dimension is larger than the width direction dimension. Furthermore, the channel forming body 12 is formed so that the opening 404, which is formed on the back surface of the case 10, and the openings 400a to 400c face each other, so that the resulting configuration makes manufacturing by aluminum casting easy.

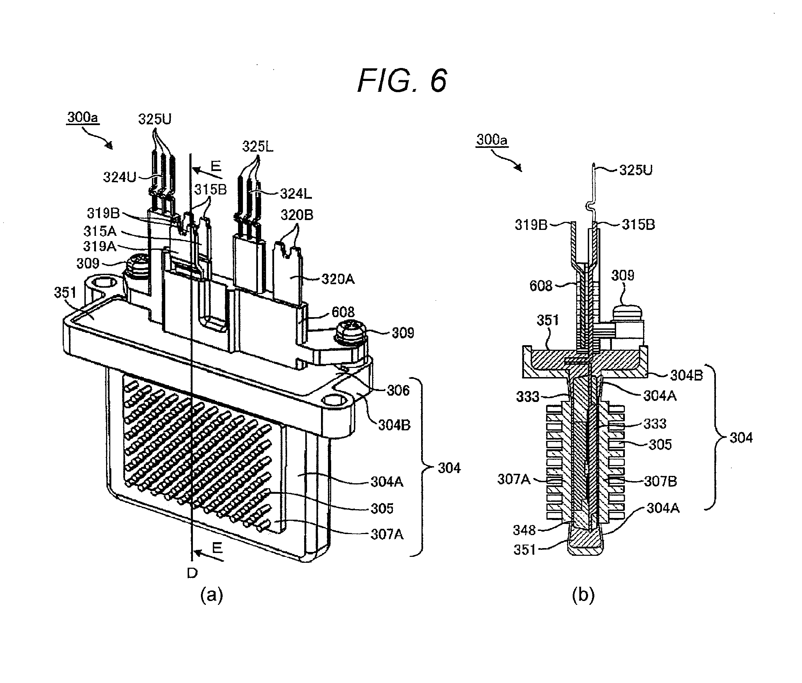

A detailed configuration of the power semiconductor modules 300a to 300c, which is used in the inverter circuit 140, will now be described with reference to FIGs. 6 to 10. The power semiconductor modules 300a to 300c all have the same structure, so the structure of the power semiconductor module 300a will be described as a representative. Also, signal terminals 325U in FIGS. 6 to 10 correspond to gate electrodes 154 and signaling emitter electrodes 155 disclosed in FIG. 2, and signal terminals 325L correspond to gate electrodes 164 and emitter electrodes 165 disclosed in FIG. 2. Furthermore, DC positive electrode terminals 315B are identical to positive electrode terminals 157 disclosed in FIG. 2, and DC negative electrode terminals 319B are identical to negative electrode terminals 158 disclosed in FIG. 2. Furthermore, AC terminals 320B are identical to AC terminals 159 disclosed in FIG. 2.

FIG. 6A is a perspective view of the power semiconductor module 300a according to the present embodiment. FIG. 6B is a sectional view of the power semiconductor module 300a according to the present embodiment taken along section D and seen from direction E.

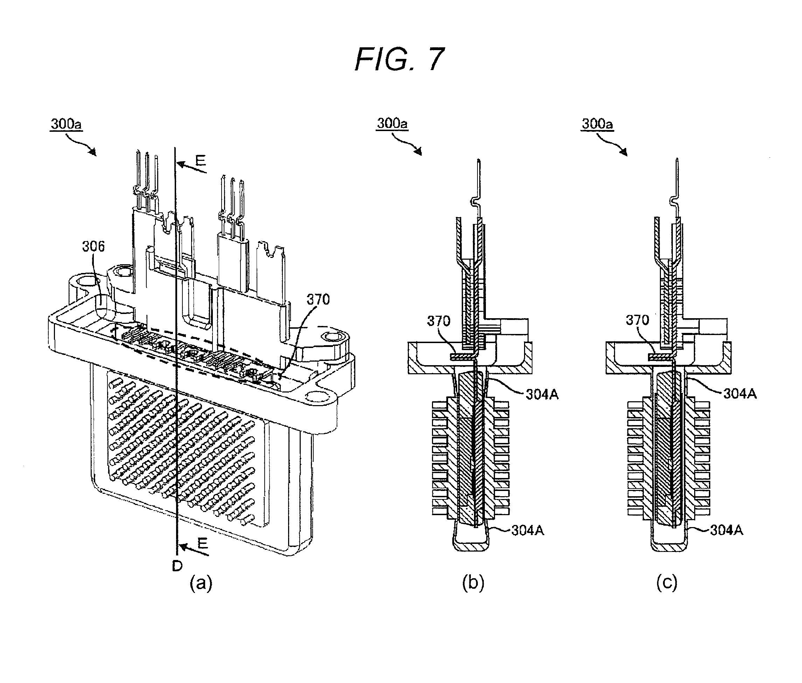

FIG. 7 is a diagram illustrating the power semiconductor module 300a after removing screws 309 and second sealing resin 351 from the state illustrated in FIG. 6, to aid understanding. FIG. 7A is a perspective view, and FIG. 7B is a sectional view taken along section D and seen from direction E as in the case of FIG. 6B. Furthermore, FIG. 7C is a sectional view before fins 305 are pressurized and a curved portion 304A is deformed.

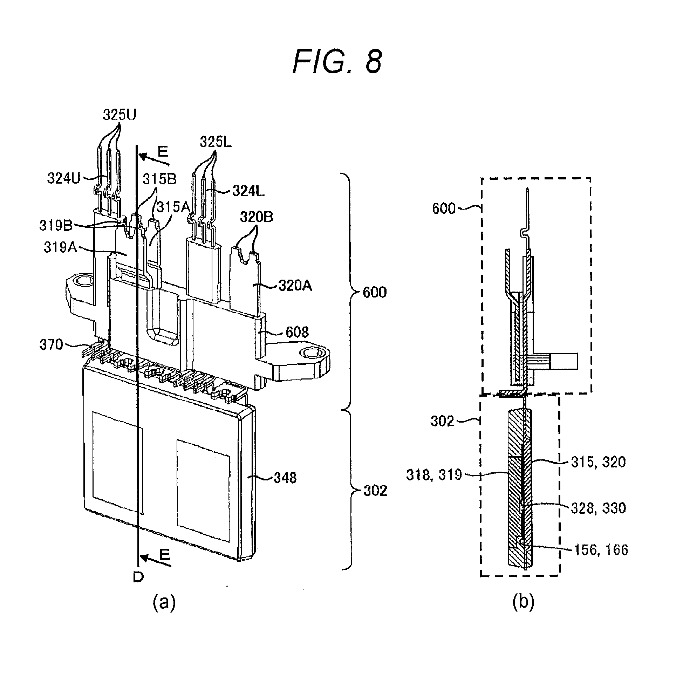

FIG. 8 is a diagram illustrating the power semiconductor module 300a after further removing a module case 304 from the state illustrated in FIG. 7. FIG. 8A is a perspective view, and FIG. 8B is a sectional view taken along section D and seen from direction E as in the case of FIG. 6B and FIG. 7B.

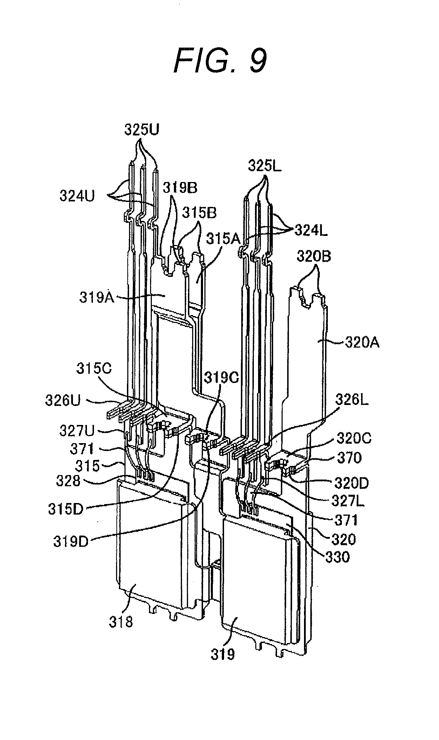

FIG. 9 is a perspective view of the power semiconductor module 300a after further removing first sealing resin 348 and a wiring insulation portion 608 from the state illustrated in FIG. 8.

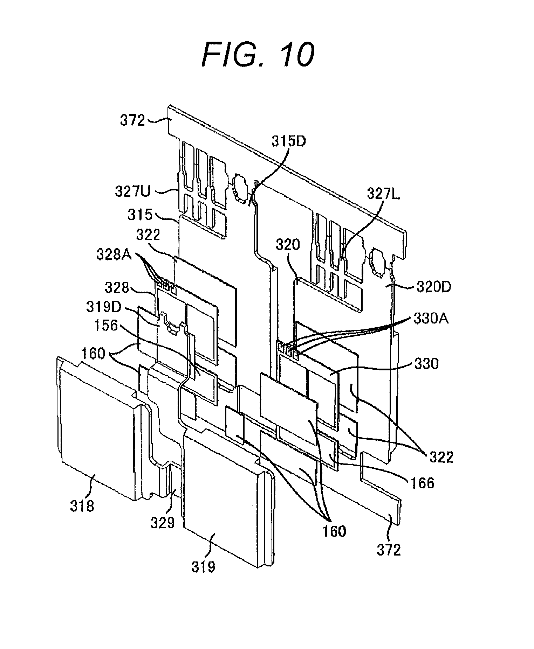

FIG. 10 is a diagram illustrating a process of assembling a module primary sealing body 302.

Power semiconductor elements (IGBT 328, IGBT 330, diode 156, diode 166), which constitute a series circuit 150 of upper and lower arms, are fastened by interposing them from both surfaces by a conductor plate 315 and a conductor plate 318, or by a conductor plate 320 and a conductor plate 319, as illustrated in FIGS. 8 and 9. The conductor plate 315 and the like are sealed by first sealing resin 348 while their heat radiation surfaces are exposed, and an insulation sheet 333 is thermal compression-bonded to the heat radiation surfaces. The first sealing resin 348 has the shape of a polyhedron (in this case, approximately rectangular parallelepiped) as illustrated in FIG. 8.

The module primary sealing body 302, which is sealed by the first sealing resin 348, is inserted into the middle of the module case 304 and, while interposing the insulation sheet 333, is thermal compression-bonded to the inner surface of the module case 304, which is a CAN-type cooler. In this case, the CAN-type cooler refers to a cooler of a can shape, which has an insertion opening 306 on one surface and a bottom on the other surface. The void remaining inside the module case 304 is filled with second sealing resin 351.

The module case 304 is made of a member having electric conductivity, for example, aluminum alloy material (Al, AlSi, AlSiC, Al-C and the like), and is integrally formed in a seamless state. The module case 304 is structured so that, except for the insertion opening 306, it is provided with no opening, and the insertion opening 306 has its outer periphery surrounded by a flange 304B. Furthermore, as illustrated in FIG. 6A, a first heat radiation surface 307A and a second heat radiation surface 307B, which have a surface larger than another surface, are arranged so as to face each other, and respective power semiconductor elements (IGBT 328, IGBT 330, diode 156, diode 166) are arranged so as to face these heat radiation surfaces. Three surfaces linked with the first heat radiation surface 307A and the second heat radiation surface 307B, which face each other, constitute a surface sealed with a width narrower than the first heat radiation surface 307A and the second heat radiation surface 307B, and the insertion opening 306 is formed on a surface of the remaining side. The shape of the module case 304 is not necessarily an exact rectangular parallelepiped, and its angles may define curved surfaces as illustrated in FIG. 6A.

Use of a metallic case of such a shape guarantees that, even when the module case 304 is inserted into the refrigerant channel 19 through which a refrigerant such as water or oil flows, any intrusion of the cooling medium into the module case 304 is prevented by a simple configuration, because sealing against the refrigerant can be secured by the flange 304B. Furthermore, fins 305 are evenly formed on the first heat radiation surface 307A and the second heat radiation surface 307B, which face each other, respectively. A curved portion 304A is also formed on the outer periphery of the first heat radiation surface 307A and the second heat radiation surface 307B, at an extremely small thickness. The thickness of the curved portion 304A is made extremely small to such an extent that it can be easily deformed by pressurizing the fins 305, thereby improving productivity after the module primary sealing body 302 is inserted.

By thermal compression-bonding the conductor plate 315 and the like to the inner wall of the module case 304 via the insulation sheet 333 as described above, it becomes possible to reduce the void between the conductor plate 315 and the like and the inner wall of the module case 304 and to transfer heat generated by the power semiconductor elements to the fins 305 efficiently. Furthermore, by endowing the insulation sheet 333 with some degree of thickness and flexibility, it becomes possible to absorb occurrence of thermal stress by the insulation sheet 333, making a use for a vehicular power conversion apparatus, which undergoes severe temperature changes, preferable.

On the exterior of the module case 304, metallic DC positive electrode wiring 315A and DC negative electrode wiring 319A are provided to electrically connect with the capacitor module 500, and DC positive electrode terminals 315B (157) and DC negative electrode terminals 319B (158) are formed on their front ends, respectively. Furthermore, metallic AC wiring 320A is provided to supply AC power to the motor generator MG1 or MG2, and AC terminals 320B (159) are formed on its front end. According to the present embodiment, as illustrated in FIG. 9, the DC positive electrode wiring 315A is connected with the conductor plate 315, the DC negative electrode wiring 319A is connected with the conductor plate 319, and the AC wiring 320A is connected with the conductor plate 320.

On the exterior of the module case 304, furthermore, metallic signal wiring 324U and 324L are provided to electrically connect with the driver circuit 174, and signal terminals 325U (154, 155) and signal terminals 325L (164, 165) are formed on their front ends, respectively. According to the present embodiment, as illustrated in FIG. 9, the signal wiring 324U is connected with the IGBT 328, and the signal wiring 324L is connected with the IGBT 328.

The DC positive electrode wiring 315A, the DC negative electrode wiring 319A, the AC wiring 320A, the signal wiring 324U, and the signal wiring 324L are integrally molded as an auxiliary mold body 600 while being insulated from each other by a wiring insulation portion 608 molded by resin material. The wiring insulation portion 608 also acts as a support member for supporting each wiring, and, as resin material used for this, thermosetting resin having insulating property or thermoplastic resin is suitable. This can secure insulating property among the DC positive electrode wiring 315A, the DC negative electrode wiring 319A, the AC wiring 320A, the signal wiring 324U, and the signal wiring 324L, thereby enabling high-density wiring.

The auxiliary mold body 600 is metal-bonded with the module primary sealing body 302 at a connection portion 370 and then fixed to the module case 304 by screws 309 extending through screw holes provided on the wiring insulation portion 608. It is possible to use TIG welding, for example, for the metal bonding between the module primary sealing body 302 and the auxiliary mold body 600 at the connection portion 370.

The DC positive electrode wiring 315A and the DC negative electrode wiring 319A are stacked on each other to face each other with the wiring insulation portion 608 interposed between them, and are shaped to extend approximately in parallel with each other. As a result of such arrangement and shaping, currents that flow instantly during a switching operation of the power semiconductor elements face each other and flow in opposite directions. As a resulting action, magnetic fields created by the currents counterbalance each other, and this action enables low inductance to be realized. Also, the AC wiring 320A and the signal terminals 325U and 325L extend in the same direction as the DC positive electrode wiring 315A and the DC negative electrode wiring 319A.

The connection portion 370, at which the module primary sealing body 302 and the auxiliary mold body 600 are connected by metal bonding, is sealed inside the module case 304 by second sealing resin 351. This makes it possible to secure a necessary insulation distance stably between the connection portion 370 and the module case 304, so that, compared with a case of no sealing, the power semiconductor module 300a can be made compact.

As illustrated in FIG. 9, on a side of the connection portion 370 near the auxiliary module body 600, an auxiliary module-side DC positive electrode connection terminal 315C, an auxiliary module-side DC negative electrode connection terminal 319C, an auxiliary module-side AC connection terminal 320C, an auxiliary module-side signal connection terminal 326U, and an auxiliary module-side signal connection terminal 326L are arranged in a row. Meanwhile, on a side of the connection portion 370 near the module primary sealing body 302, along a surface of the first sealing resin 348 having a polyhedron shape, an element-side DC positive electrode connection terminal 315D, an element-side DC negative electrode connection terminal 319D, an element-side AC connection terminal 320D, an element-side signal connection terminal 327U, and an element-side signal connection terminal 327L are arranged in a row. Such a structure of arranging respective terminals in a row at the connection portion 370 facilitates manufacturing of the module primary sealing body 302 by transfer mold.

Now, the positional relationship of respective terminals, when parts extending outwards from the first sealing resin 348 of the module primary sealing body 302 are considered, for each type, as a terminal, will be described. In the following description, a terminal consisting of the DC positive electrode wiring 315A (including the DC positive electrode terminals 315B and the auxiliary module-side DC positive electrode connection terminal 315C) and the element-side DC positive electrode connection terminal 315D will be referred to as a positive electrode-side terminal, a terminal consisting of the DC negative electrode wiring 319A (including the DC negative electrode terminals 319B and the auxiliary module-side DC negative electrode connection terminal 319C) and the element-side DC negative electrode connection terminal 315D will be referred to as a negative electrode-side terminal, a terminal consisting of the AC wiring 320A (including the AC terminals 320B and the auxiliary module-side AC connection terminal 320C) and the element-side AC connection terminal 320D will be referred to as an output terminal, a terminal consisting of the signal wiring 324U (including the signal terminals 325U and the auxiliary module-side signal connection terminal 326U) and the element-side signal connection terminal 327U will be referred to as an upper arm signal terminal, and a terminal consisting of the signal wiring 324L (including the signal terminals 325L and the auxiliary module-side signal connection terminal 326L) and the element-side signal connection terminal 327L will be referred as a lower arm signal terminal.

Any of the above-described terminals protrudes from the first sealing resin 348 and the second sealing resin 351 through the connection portion 370, and respective protruding parts (the element-side DC positive electrode connection terminal 315D, the element-side DC negative electrode connection terminal 319D, the element-side AC connection terminal 320D, the element-side signal connection terminal 327U, and the element-side signal connection terminal 327L) from the first sealing resin 348 are arranged in a row along a surface of the first sealing resin 348, which has a polyhedron shape as described above. Furthermore, the positive electrode-side terminal and the negative electrode-side terminal protrude from the second sealing resin 351 in a stacked state, and extend out of the module case 304. This configuration guarantees that, during mold clamping when the module primary sealing body 302 is manufactured by sealing the power semiconductor elements using the first sealing resin 348, it is possible to prevent excessive stress from being applied to the connection part between the power semiconductor elements and the terminals and to avoid creation of a gap in the molds. Furthermore, currents flowing in opposite directions through the positive electrode-side terminal and the negative electrode-side terminal, which are stacked on each other, respectively, generate magnetic fluxes in such directions that offset each other, enabling low inductance to be realized.

Regarding the side of the auxiliary module body 600, the auxiliary module-side DC positive electrode connection terminal 315C and the auxiliary module-side DC negative electrode connection terminal 319C are formed on front ends of the DC positive electrode wiring 315A and the DC negative electrode wiring 319A, which are on sides opposite to the DC positive electrode terminals 315B and the DC negative electrode terminals 319B, respectively. Furthermore, the auxiliary module-side AC connection terminal 320C is formed on a front end of the AC wiring 320A, which is on a side opposite to the AC terminals 320B. The auxiliary module-side signal connection terminals 326U and 326L are formed on front ends of the signal wiring 324U and 324L, which are on sides opposite to the signal terminals 325U and 325L, respectively.

Meanwhile, regarding the side of the module primary sealing body 302, the element-side DC positive electrode connection terminal 315D, the element-side DC negative electrode connection terminal 319D, and the element-side AC connection terminal 320D are formed on the conductor plates 315, 319, and 320, respectively. Furthermore, the element-side signal connection terminals 327U and 327L are connected with the IGBTs 328 and 330, respectively, by bonding wires 371.

As illustrated in FIG. 10, the DC positive electrode-side conductor plate 315 and the AC output-side conductor plate 320, as well as the element-side signal connection terminals 327U and 327L, are integrally processed so as to be arranged in an approximately identical plane shape, while being linked to a common tie bar 372. To the conductor plate 315, the collector electrode of the IGBT 328 of the upper arm side and the cathode electrode of the diode 156 of the upper arm side are fastened. To the conductor plate 320, the collector electrode of the IGBT 330 of the lower arm side and the cathode electrode of the diode 166 of the lower arm side are fastened. On the IGBTs 328 and 330 and the diodes 155 and 166, the conductor plate 318 and the conductor plate 319 are arranged in an approximately identical plane shape. To the conductor plate 318, the emitter electrode of the IGBT 328 of the upper arm side and the anode electrode of the diode 156 of the upper arm side are fastened. To the conductor plate 319, the emitter electrode of the IGBT 330 of the lower arm side and the anode electrode of the diode 166 of the lower arm side are fastened. Each power semiconductor element is fastened to an element fastening portion 322, which is provided on each conductor plate, via a metal bonding material 160. The metal bonding material 160 includes, for example, soldering material and low-temperature sintering bonding material containing silver sheet and fine metal particles.

Each power semiconductor element has a flat structure of a plate shape, and each electrode of the power semiconductor element is formed on a front/back surface. As illustrated in FIG. 10, each electrode of the power semiconductor element is interposed by the conductor plate 315 and the conductor plate 318, or by the conductor plate 320 and the conductor plate 319. That is, the conductor plate 315 and the conductor plate 318 are stacked/arranged to face each other approximately in parallel with each other via the IGBT 328 and the diode 156. Likewise, the conductor plate 320 and the conductor plate 319 are stacked/arranged to face each other approximately in parallel with each other via the IGBT 330 and the diode 166. Furthermore, the conductor plate 320 and the conductor plate 318 are connected via an intermediate electrode 329. This connection electrically connects the upper arm circuit and the lower arm circuit and forms an upper/lower arm series circuit. As described above, the IGBT 328 and the diode 156 are interposed between the conductor plate 315 and the conductor plate 318, the IGBT 330 and the diode 166 are interposed between the conductor plate 320 and the conductor plate 319, and the conductor plate 320 and the conductor plate 318 are connected via the intermediate electrode 329. Thereafter, the control electrode 328A of the IGBT 328 and the element-side signal connection terminal 327U are connected by a bonding wire 371, and the control electrode 330A of the IGBT 330 and the element-side signal connection terminal 327L are connected by a bonding wire 371.

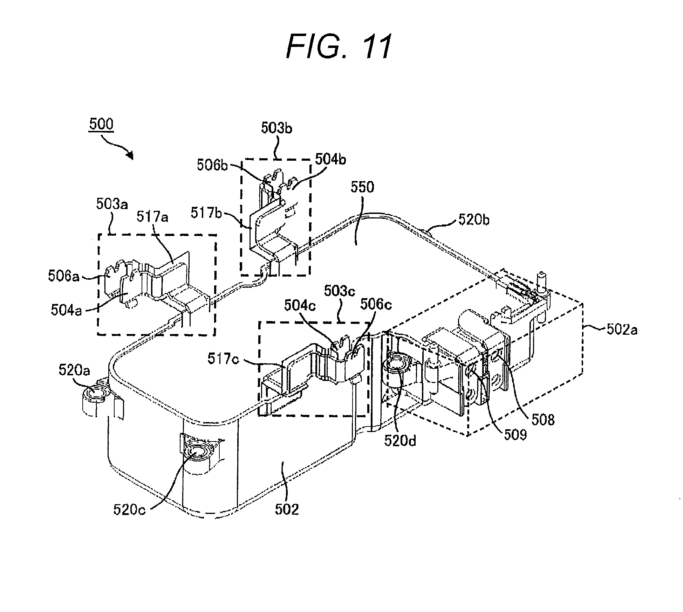

FIG. 11 is a perspective view illustrating a structure of a capacitor module 500. Although not illustrated in FIG. 11, a plurality of film capacitors are provided inside a capacitor case 502, and the film capacitors are electrically connected to a negative electrode conductor plate and a positive electrode conductor plate. Between the negative electrode conductor plate and the positive electrode conductor plate, an insulating member is arranged to realize low inductance, and the negative electrode conductor plate and the positive electrode conductor plate are configured in a stacked state. That is, the negative electrode conductor plate and the positive electrode conductor plate constitute a stacked conductor plate.

A resin sealing material 550 fills the interior of the capacitor case 502 in order to fix the film capacitors and the stacked conductor plate to the capacitor case 502. A negative electrode-side power source terminal 508 and a positive electrode-side power source terminal 509 are electrically connected to the stacked conductor plate, respectively, protrude from an exposed surface of the resin sealing material 550, and are bent at a corner of a side surface of the capacitor case 502. The positive electrode-side power source terminal 509 and the negative electrode-side power source terminal 508 are, as described with reference to FIG. 2, supplied with DC power via the DC-side connector 138.

Capacitor terminals 503a to 503c are electrically connected to the stacked conductor plate, respectively, and are provided so as to correspond to the positive electrode terminal 157 (315B) and the negative electrode terminal 158 (319B) of the semiconductor module 300. The capacitor terminals 503a to 503c are connected to the power semiconductor modules 300a to 300c, respectively. Between a negative electrode-side capacitor terminal 504a and a positive electrode-side capacitor terminal 506a, which constitute the capacitor terminal 503a, an insulation sheet 517a is provided to secure insulation. The other capacitor terminals 503b to 503c are configured likewise.

The capacitor case 502 is provided with holes 520a to 520d so that fixing means for fixing the capacitor module 500 to the channel forming body 12, for example, screws extend through the holes 520a to 520d.

Furthermore, a protruding containing portion 502a is formed on a side surface on a longer side of the capacitor case 502. The protruding containing portion 502a contains electric circuit elements electrically connected in series or in parallel with regard to the film capacitors and the power source terminals 508 and 509. According to the present embodiment, a capacitor for noise removal is contained, which removes noise from the battery 136 and which is electrically connected to the ground. Since this capacitor is compact compared with the film capacitors, the height of the protruding containing portion 502a is formed smaller than the height of the capacitor case 502. That is, a space is formed below the protruding containing portion 502a. The channel forming body 12 illustrated in FIG. 3 forms a part of the refrigerant channel 19 in this space. This makes it possible to cool the capacitor for noise removal and to suppress local increase of the sectional area of the refrigerant channel 19 and thus prevent increase of pressure loss.

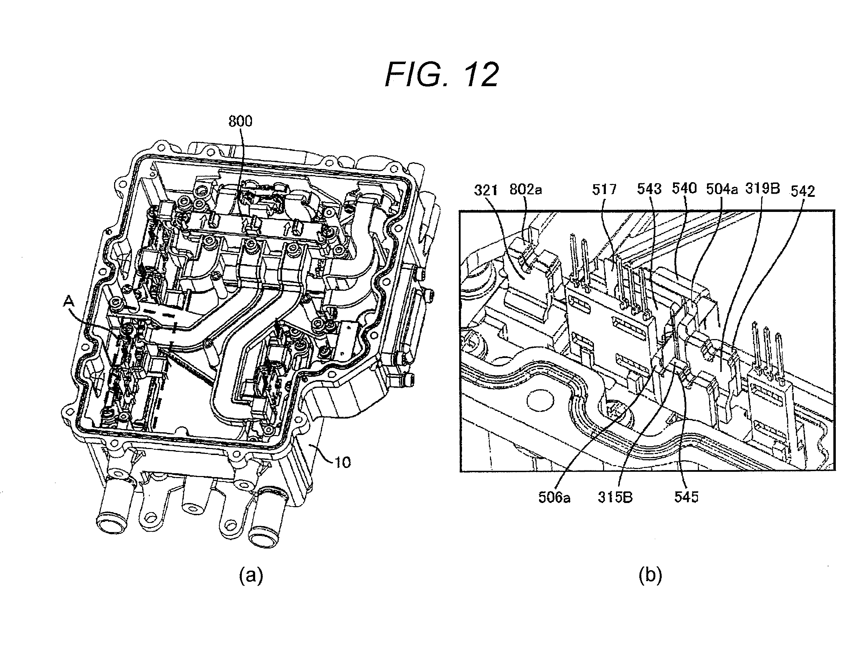

FIG. 12A is an external perspective view when power semiconductor modules 300a to 300c, a capacitor module 500, and a busbar assembly 800 are fitted together to a case 10. FIG. 12B is a magnified view of part A of FIG. 12A.

A DC positive electrode terminal 315B (157), a DC negative electrode terminal 319B (158), an AC terminal 321 (159), and a second sealing portion 601B extend in a longitudinal direction of the case 10 toward the cover 8. The area of current path of the DC positive electrode terminal 315B (157) and the DC negative electrode terminal 319B (158) is extraordinarily smaller than the area of current path of the stacked conductor plate inside the capacitor module 500. Due to this, when currents flow from the stacked conductor plate to the DC positive electrode terminal 315B (157) and the DC negative electrode terminal 319B (158), the area of current path changes substantially. That is, currents concentrate in the DC positive electrode terminal 315B (157) and the DC negative electrode terminal 319B (158).

According to the present embodiment, the negative electrode-side capacitor terminal 504a has a standup portion 540, which stands up from the stacked conductor plate, and has a connection portion 542 at its front end. Furthermore, the positive electrode-side capacitor terminal 506a has a standup portion 543, which stands up from the stacked conductor plate, and has a connection portion 545 at its front end. The DC negative electrode terminal 319B (158) and the DC positive electrode terminal 315B (157) of the power semiconductor module 300a are connected so as to be interposed between the connection portion 542 and the connection portion 545.

As a result of this, the negative electrode-side capacitor terminal 504a and the positive electrode-side capacitor terminal 506a constitute a stacked structure via an insulation sheet until right before the connection portions 542 and 545, making it possible to lower the inductance of wiring parts of the capacitor terminals, in which currents concentrate. Furthermore, the front end of the DC negative electrode terminal 319B (158) and the lateral side of the connection portion 542 are connected by welding, and the front end of the DC positive electrode terminal 315B (157) and the lateral side of the connection portion 545 are likewise connected by welding. This makes it possible to improve productivity, in addition to improving characteristics by lowering inductance.

The front end of the AC terminal 321 (159) of the power semiconductor module 300a is connected to the front end of the AC busbar 802a by welding. Regarding production equipment for welding, making a welding machine to be able to move in a plurality of directions with regard to the welding target is not desirable from the point of view of productivity and cost, in connection with making the production equipment complicated. Therefore, according to the present embodiment, welding spots of the AC terminal 321 (159) and welding spots of the DC negative electrode terminal 319B (158) are arranged on a straight line along a longitudinal-direction side of the case 10. This makes it possible to perform a plurality of welding while moving the welding machine in one direction and thus improve productivity.

Furthermore, as illustrated in FIGS. 4 to 12, a plurality of power semiconductor modules 300a and 300b are arranged on a straight line along a longitudinal-direction side of the case 10. This makes it possible to further improve productivity when welding the plurality of power semiconductor modules 300a to 300b.

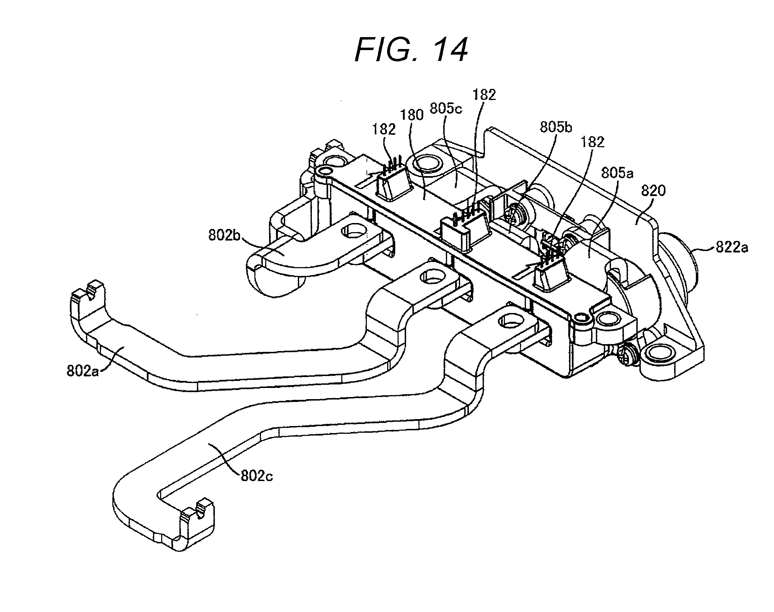

FIG. 13 is an exploded perspective view of the case 10, to which the power semiconductor modules 300a to 300c and the capacitor module 500 are fitted together, and the busbar assembly 800. FIG. 14 is an external perspective view of the busbar assembly 800 after removing the retaining member 803.

As illustrated in FIGS. 13 and 14, the busbar assembly 800 includes AC busbars 802a to 802c and the retaining member 803 for holding and fixing the AC busbars 802a to 802c. Also, the busbar assembly 800 includes the current sensor 180 to detect AC currents flowing along the AC busbars 802a to 802c.

The AC busbars 802a to 802c are bent in front of penetration holes of the current sensor 180 in a direction away from the capacitor module 500 and are connected to AC busbars 805a to 805c in front of the holes of the current sensor 180. The AC busbars 805a to 805c are inserted through the penetration holes of the current sensor 180 and are connected to AC terminals 822a to 822c, respectively.

As illustrated in FIG. 13, the AC busbars 802a to 802c, the AC busbars 805a to 805c, and the current sensor 180 are held and insulated by the retaining member 803 formed of resin.

The busbar assembly 800 is fixed to the case 10 by the retaining member 803. When heat is transferred to the case 10 from an outside area, the case 10 can be cooled by a refrigerant flowing through the channel forming body 12. Since the busbar assembly 800 is fixed to the case 10 including the channel forming body 12, the current sensor 180 held on the busbar assembly 800 can also be cooled. Although the current sensor 180 is easily affected by heat, reliability of the current sensor 180 can be improved owing to the above-described structure.

As illustrated in FIG. 13, the retaining member 803 includes support members 807a to 807d to support the driver circuit board 22 illustrated in FIG. 4. Screw holes are formed in the front ends of the support members 807a to 807d for fixing the driver circuit board 22.

Also, the retaining member 803 includes protrusions 806a and 806b upwardly extending from a position at which the current sensor 180 is arranged. Each of the protrusions 806a and 806b is penetrated through the current sensor 180. As illustrated in FIG. 14, the current sensor 180 includes signal lines 182 extending toward a direction to which the driver circuit board 22 is arranged. The signal lines 182 are connected to a wiring pattern of the driver circuit board 22 by soldering. According to the present embodiment, the retaining member 803, the support members 807a to 807d, and the protrusions 806a and 806b are integrally formed by using resin.

In this way, the relative positions of the current sensor 180 and the driver circuit board 22 are determined by the retaining member 803, and thus assembling and soldering of the signal lines 182 and the driver circuit board 22 can be easily carried out. Also, since providing mechanism which holds the current sensor 180 and the driver circuit board 22 to the retaining member 803, the number of parts of the power conversion apparatus can be reduced as a whole. In the present embodiment, since the power conversion apparatus 200 is arranged close to a vibration source such as an engine, the retaining member 803 includes the support members 807a and 807b to indicate a close area of a the center part of the driver circuit board 22, and reduce the influence of vibration on the driver circuit board 22. For example, since the support members 807a and 807b support the center part of the driver circuit board 22, resonance frequencies of the driver circuit board 22 can be higher than frequencies of vibration transmitted from the engine and the like, and thus the influence of vibration on the driver circuit board 22 from the engine and the like can be reduced.

Also, the retaining member 803 of the busbar assembly 800 is fixed to the case 10 using screws 824.

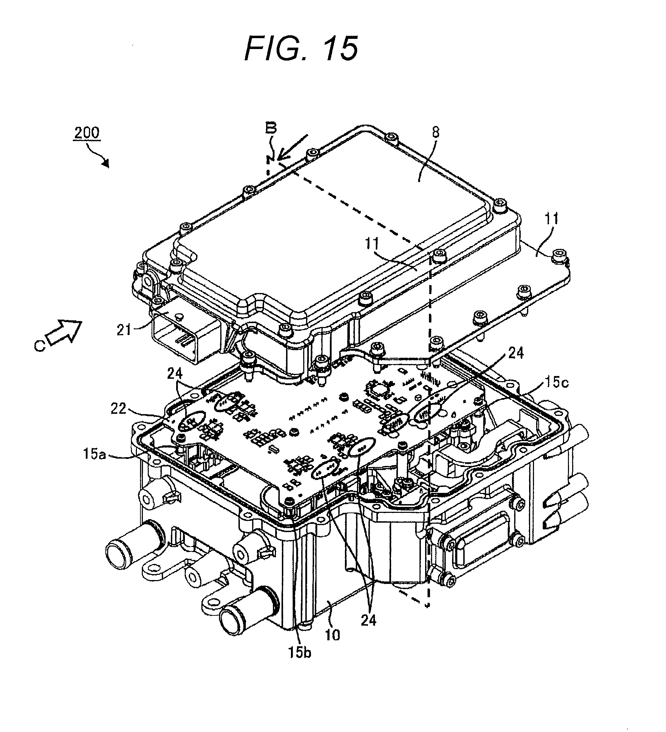

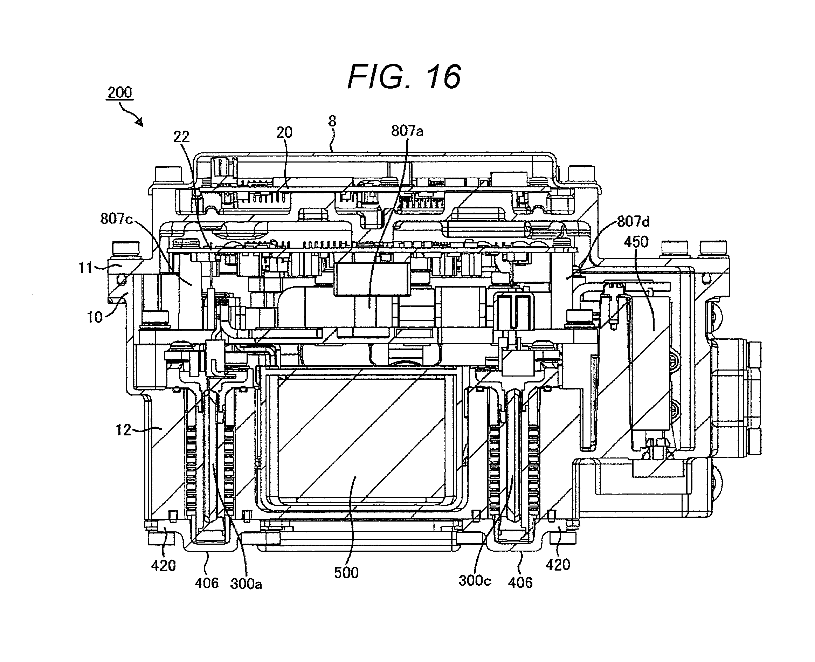

FIG. 15 is a perspective view of the power conversion apparatus 200 with a metal base plate 11 separated. Furthermore, FIG. 16 is a sectional view of the power conversion apparatus 200 seen from the direction of the arrow of section B of FIG. 15.

As illustrated in FIG. 13, the current sensor 180 is arranged above the capacitor module 500. The driver circuit board 22 is arranged above the current sensor 180 and further supported by the support members 807a to 807d provided in the busbar assembly 800 illustrated in FIG. 14. Also, four corners of the driver circuit board 22 are connected to the case 10 via support members 15a to 15d (15d is not illustrated).

The metal base plate 11 is arranged above the driver circuit board 22. In the present embodiment, the circumferential part of an opening of the case 10 is covered with the metal base plate 11. The control circuit board 20 is contained in a space formed by the metal base plate 11 and the cover 8.

Since the current sensor 180, the driver circuit board 22, and the control circuit board 20 are vertically stacked in a manner such that the control circuit board 20 is most distant from the high power semiconductor modules 300a to 300c, mixing of switching noise, for example, can be suppressed. Also, the metal base plate 11 is electrically connected to the channel forming body 12 which is electrically connected to ground. Owing to the metal base plate 11, mixing of noise from the driver circuit board 22 into the control circuit board 20 can be reduced.

When the current sensor 180 and the driver circuit board 22 are electrically connected, if wiring connectors are used, it is desired to simplify the connection process and prevent connection errors. Referring to FIG. 15, holes 24 are formed through the driver circuit board 22. Furthermore, signal terminals 325U and 325L of the power semiconductor modules 300a to 300c are inserted in the holes 24 and are connected to the wiring pattern of the driver circuit board 22 by soldering. Also, surfaces facing the channel forming body 12 are soldered from a side of the driver circuit board 22 opposite to the channel forming body 12.

As a result of this, the signal lines can be connected without wiring connectors, and thus productivity can be improved. Also, productivity can be further improved by soldering the signal terminals 325U and 325L of the power semiconductor module 300 and the signal lines 182 of the current sensor 180 from the same direction.

Furthermore, the driver circuit board 22 of the present embodiment mounts driving circuits (not illustrated) such as driver IC chips, on a surface side facing the channel forming body 12. This structure guarantees that transferring heat of the solder-bonding to driver chips, for example, is suppressed, and damages of the driver chips by the solder-bonding are prevented. Also, since tall parts such as a transformer installed on the driver circuit board 22 are arranged in a space between the capacitor module 500 and the driver circuit board 22, the height of the power conversion apparatus 200 can be lowered as a whole.

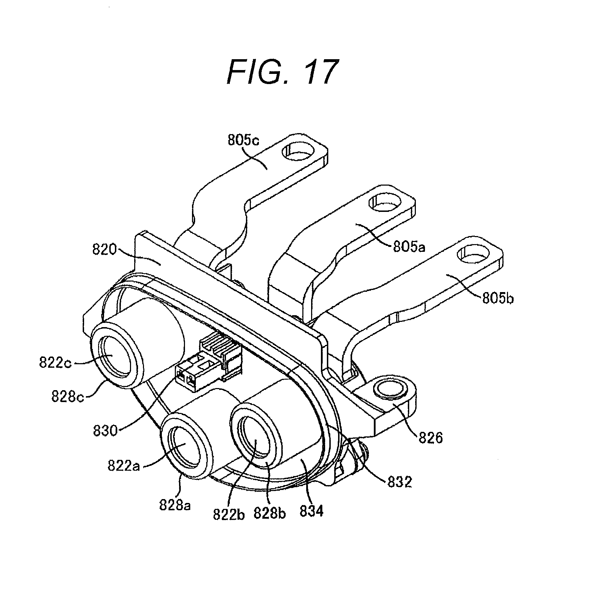

FIG. 17 is a magnified view of peripheral parts of the AC terminals 822a to 822c. The AC busbars 805a to 805c configured to be inserted through the current sensor 180 are supported by a first support member 820, and front ends of the AC busbars 805a to 805c connected to the AC terminals 822a to 822c. The AC terminals 822a to 822c are cylindrical female connectors.

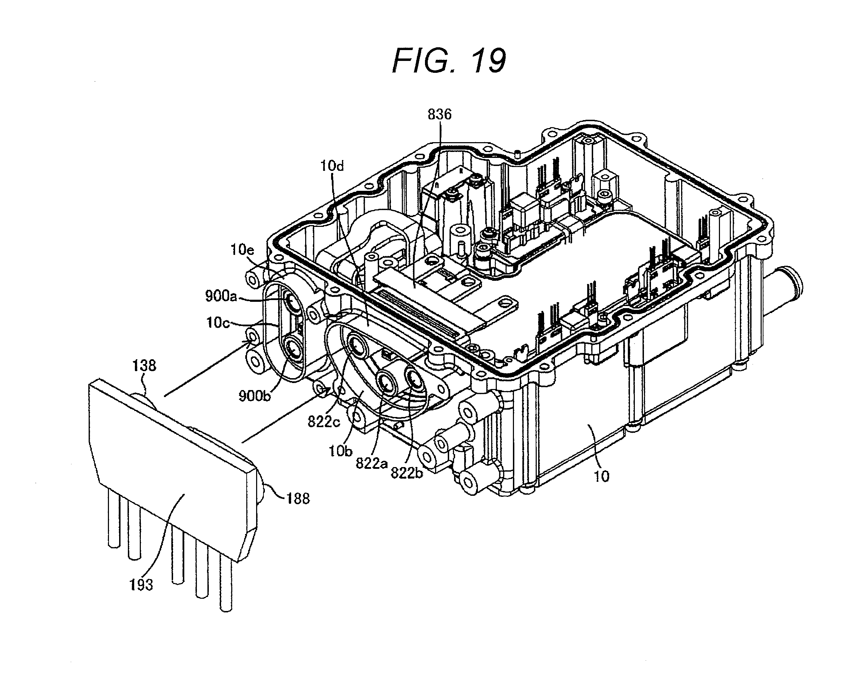

The first support member 820 is fixed to the case 10 through a fixing portion 826. Also, the first support member 820 includes the terminal covers 828a to 828c configured by covering the front ends of the AC terminals 822a to 822c protruding toward the outside of the case 10. The AC terminals 822a to 822c are connected to the connector of the vehicle side 193 illustrated in FIG. 19. At the time of the transport of the power conversion apparatus 200 to the assembly or test of the vehicle, or the part replacement, the connector 193 is in a released state. Therefore, the AC terminals may be exposed. At that time, since it is necessary to prevent electric shock when a work touches the exposed AC terminals 822a to 822c, the above configuration makes it possible to prevent electric shock by covering the front ends of the AC terminals 822a to 822c with an insulating material.

Also, the first support member 820 holds a connection detection circuit 830 that detects a state in which the AC connector 188 illustrated in FIG. 19 is separated from the first support member 820, that is, a state in which the AC connector 188 and the AC terminals 822a to 822c are not electrically connected. The connection detection circuit 830 detects that the same connection detection circuit provided in the AC connector 188 side is fitted to a connection state. When the connection detection circuit 830 detects that the AC connector 188 and the AC terminals 822a to 822c are not electrically connected, corresponding detection information is transmitted to the control circuit board 20, and the control circuit board 20 performs control such that the driving of the power semiconductor modules 300a to 300c are suppressed or stopped according to the detection information.

Also, the connection detection circuit 830 configures a closed circuit with the control circuit board 20, the AC terminal 822a, etc. When any one portion is cut and is not electrically connected, the control circuit board 200 generates a signal that suppresses or stops the driving of the power semiconductor modules.

Due to the above configuration, when the worker removes the connector 193 of the vehicle side and the AC terminals 822a to 822c are exposed, for example, at the time of the assembly of the power conversion apparatus 200 with the vehicle, the test or the part replacement, the safety of the worker can be secured by stopping the driving of the power conversion apparatus 200. Also, in order to prevent the connection detection circuit 830 from unexpectedly stopping the driving of the power conversion apparatus 200 by mistaken omission due to vibration, the connection detection circuit 830 is supported to the first support member 820 firmly fixed to the case 10.

Also, the first support member 820 includes a protrusion 832 protruding toward the outside of the case 10. The protrusion 832 is formed to surround the AC terminals 822a to 822c, and the outer periphery of the protrusion 832 is fitted into the inner periphery of an opening 10b illustrated in FIG. 5. Therefore, it is possible to improve the positional accuracy of the AC terminals 822a to 822c and the inner peripheral portion of the opening 10b.. Also, water-proof effect can also be improved. Furthermore, since the contact area between the first support member 820 holding the AC terminals 822a to 822c and the case 10 can be greatly increased, resonance frequencies of the AC terminals 822a to 822c can be higher than frequencies of vibration transmitted from the engine and the like. Therefore, the vibration resistance in the vicinity of the AC terminals 822a to 822c can be increased.

Also, the first support member 820 includes a shield portion 834 to cover the opening 10b of the case 10. The shield portion 834 is formed to fill a gap between terminal covers 828a to 828c and the protrusion 832. At the time of the transport only the power conversion apparatus 200 or the assembly or test of the vehicle, or the part replacement, foreign substances such screws or tools may be mixed into the case 10. The foreign substances mixed into the case 10 causes the short circuit of the electrical connection portions or the damage of the parts, leading to the destruction of the power conversion apparatus 200. Therefore, due to the above configuration, it is possible to prevent foreign substances from being mixed from the outside by shielding the inside and the outside of the case 10 by the shield portion 834.

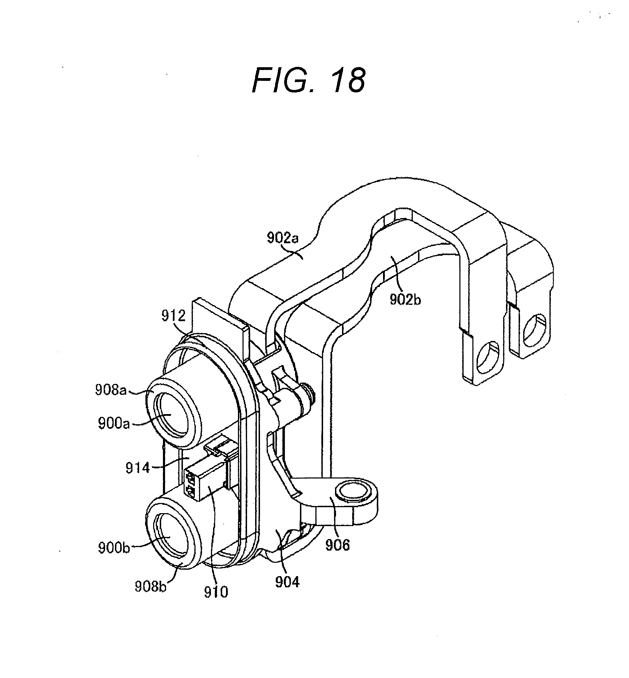

FIG. 18 is a magnified view of peripheral parts of a negative electrode-side DC terminal 900a and a positive electrode-side DC terminal 900b.

One end of the negative electrode-side DC busbar 902a is connected to the negative electrode side power source terminal 508 of the capacitor module 500, and another end is connected to the DC terminal 900a. Similarly, one ends of the positive electrode-side DC busbar 902b is connected to the positive electrode-side power source terminal 509 of the capacitor module 500, and the other end is connected to the DC terminal 900b. The DC terminals 900a and 900b are cylindrical female connectors.

The second support member 904 is fixed to the case 10 by the fixing portion 906. Also, the second support member 904 includes the terminal covers 908a and 908b configured by covering the front ends of the DC terminals 900a and 900b protruding toward the outside of the case 10. The DC terminals 900a and 900b are connected to the connector 193 of the vehicle side illustrated in FIG. 19. At the time of the transport of the power conversion apparatus 200 or the assembly or test of the vehicle, or the part replacement, the connector 193 is in a released state. Therefore, the DC terminals may be exposed. At that time, since it is necessary to prevent electric shock when a work touches the exposed DC terminals 900a and 900b, the above configuration makes it possible to prevent electric shock by covering the front ends of the DC terminals 900a and 900b with an insulating material.

Also, the second support member 904 holds a connection detection circuit 910 that detects a state in which the DC-sideconnector 138 illustrated in FIG. 19 is separated from the second support member 904, that is, a state in which the DC connector-side 138 and the DC terminals 900a and 900b are not electrically connected. The connection detection circuit 910 detects that the same connection detection circuit provided in the side of the DC-side connector 138 side is fitted to a connection state. When the connection detection circuit 910 detects that the DC-side connector 138 and the DC terminals 900a and 900b are not electrically connected, corresponding detection information is transmitted to the control circuit board 20, and the control circuit board 20 performs control such that the driving of the power conversion apparatus 200 is suppressed or stopped according to the detection information.

Also, the connection detection circuit 830 configures a closed circuit with the control circuit board 20 and the DC terminals. When any one portion is cut and is not electrically connected, the control circuit board 200 generates a signal that suppresses or stops the driving of the power semiconductor module.

Also, in the present embodiment, the connection detection circuit 830 is also provided in the AC terminals 822a to 822c side, and configures a closed circuit with the control circuit board 20, the DC terminals, and the AC terminals. When any one portion is cut and is not electrically connected, the control circuit board 200 is configured to generate a signal that suppresses or stops the driving of the power semiconductor module. Also, as illustrated in FIG. 19, in a case where the connector 193 is integrally configured with the DC-side connector 138 and the AC connector 188, when only one of the connection detection circuit 830 and the connection detection circuit 910 is provided, the control may be performed such that the driving of the power conversion apparatus 200 is suppressed or stopped.

Due to the above configuration, when the worker removes the connector 193 of the vehicle side and the DC terminals 900a and 900b are exposed, for example, at the time of the assembly of the power conversion apparatus 200 with the vehicle, the test or the part replacement, the safety of the worker can be secured by stopping the driving of the power conversion apparatus 200. Also, in order to prevent the connection detection circuit 910 from unexpectedly stopping the driving of the power conversion apparatus 200 by mistaken omission due to vibration, the connection detection circuit 910 is supported to the second support member 904 firmly fixed to the case 10.

Also, the second support member 904 includes a protrusion 912 protruding toward the outside of the case 10. The protrusion 912 is formed to surround the DC terminals 900a and 900b, and the outer periphery of the protrusion 832 is fitted into the inner periphery of the opening 10c illustrated in FIG. 5. Therefore, it is possible to improve the position accuracy of the DC terminals 900a and 900b and the inner peripheral portion of the opening 10c. Also, the water-proof effect can also be improved. Furthermore, since the contact area between the second support member 904 holding the DC terminals 900a and 900b and the case 10 can be greatly increased, the resonance frequency of the DC terminals 900a and 900b can be made higher than the frequency of vibration transmitted from the engine and the like. Therefore, the vibration resistance in the vicinity of the DC terminals 900a and 900b can be increased.

Also, the second support member 904 includes a shield portion 914 to cover the opening 10c of the case 10. The shield portion 914 is formed to fill the gap between the terminal covers 908a and 908b and the protrusion 912. At the time of the transport of the power conversion apparatus 200 or the assembly or test of the vehicle, or the part replacement, foreign substances such screws or tools may be mixed into the case 10. The foreign substances mixed into the case 10 causes the short circuit of the electrical connection portions or the damage of the parts, leading to the destruction of the power conversion apparatus 200. Therefore, due to the above configuration, it is possible to prevent foreign substances from being mixed from the outside by shielding the inside and the outside of the case 10 by the shield portion 914.

FIG. 19 is an exploded perspective view of the case 10, to which the AC terminals 822a to 822c and the DC terminals 900a and 900b are fitted together, and the vehicle-side connector 193.

The case 10 includes a first wall 10d protruding from an edge of an opening 10b toward the outside of the case 10. The first wall 10d may be integrally formed with the case 10. The AC-side connector 188 is connected to the AC terminals 822a to 822c supported to the first support member 820 via a space surrounded by the first wall 10d. Therefore, since the AC terminals 822a to 822c are covered with the first wall 10d, the AC terminals 822a to 822c can be protected from impact from the outside. Also, since the protrusion 832 of the first support member 820 and the first wall 10d are contacted in a wide area, the position accuracy of the AC terminals 822a to 822c can be increased, and the resonance frequencies of the AC terminals 822a to 822c can be made higher than the frequency of vibration transmitted from the engine and the like. Furthermore, since the AC-side connector 188 is also configured to contact the inner periphery of the first wall 10d, the position accuracy of the AC connector-side 188 can be increased, and the resonance frequency of the AC wiring of the AC-side connector 188 can be made higher than the frequency of vibration transmitted from the engine and the like.

Similarly, the case 10 includes a second wall 10e protruding from an edge of an opening 10c toward the outside of the case 10. The second wall 10e may be integrally formed with the case 10. The DC connector-side 138 is connected to the DC terminals 900a and 900b supported to the second support member 904 via a space surrounded by the second wall 10e. Therefore, since the DC terminals 900a and 900b are covered with the second wall 10e, the DC terminals 900a and 900b can be protected from impact from the outside. Also, since the protrusion 912 of the second support member 904 and the second wall 10e are contacted in a wide area, the position accuracy of the DC terminals 900a and 900b can be increased, and the resonance frequencies of the DC terminals 900a and 900b can be made higher than the frequency of vibration transmitted from the engine and the like. Furthermore, since the DC-side connector 138 is also configured to contact the inner periphery of the second wall 10e, the position accuracy of the DC-side connector 138 can be increased, and the resonance frequency of the DC wiring of the DC-side connector 138 can be made higher than the frequency of vibration transmitted from the engine and the like.

A metal plate 836 is a member that fixes the first support member 820 to the case 10, with the first support member 820 illustrated in FIG. 17 being interposed between the metal plate 836 and the case 10. The metal plate 836 is formed to cover at least a part of the surfaces of the AC busbars 822a to 822c of a side where the control circuit board illustrated in FIG. 4 is arranged. The control circuit board 20 and the wiring for transmitting the control signal are easily influenced by the AC terminals 822a to 822c or the AC busbars 805a to 805c due to a slight current. Therefore, noise can be blocked by covering the AC terminals 822a to 822c or the AC busbars 805a to 805c with the metal plate 836 being the conductive member.

In the present embodiment, in the connector 193, the DC connector-side 138 and the AC connector 188 are integrally formed. Therefore, the number of components can be reduced, and the connecting work can be simplified, leading to an improvement in productivity. However, on the other hand, when the DC-side connector 138 and the AC connector 188 are installed in a batch, the connector 193 becomes large and is easily deformed. Thus, a bias in insertion stress of the connector 193 may occur. As a result, the connector 193 or the components of the power conversion apparatus 200 may be damaged, or a bias may occur in a seal member of the connector 193 and the case 10, degrading a water-proof property. Also, when the connector 193 and the power conversion apparatus 200 are mounted on the vehicle in a state that the bias occurs in the insertion stress of the connector 193, a required vibration resistance may not be exhibited.

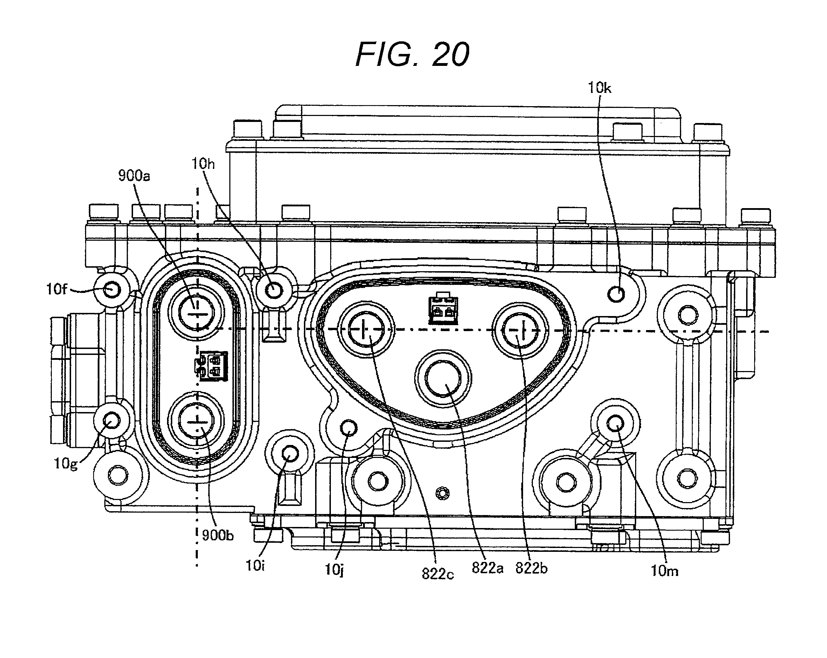

Therefore, the AC terminals 822a to 822c and the DC terminals 900a and 900b of the present embodiment are arranged to reduce the deformation of the connector 193 where the DC connector-side 138 and the AC connector 188 are integrally configured. Specifically, as illustrated in FIG. 20, the AC terminals 822a to 822c and the DC terminals 900a and 900b are arranged in a side surface of the case 10, and the side surface of the case 10 forms a rectangular shape configured by short-direction sides and longitudinal-direction sides. The DC terminals 900a and 900b are arranged in parallel along one side of the short-direction side of the case 10, and the AC terminals 822a to 822c are arranged in parallel along one side of the longitudinal-direction side of the case 10.

Therefore, due to a line passing through the DC terminals 900a and 900b and a line passing through the AC terminals 822a and 822c, a substantially T-shape or L-shaped titled about 90 degrees is formed. Since the positions of a height direction (a side surface of the short-direction of the case 10) and a width direction (a side surface of the longitudinal-direction of the case 10) of the connector 193 are determined at the same time, the connector 193 can be fixed to each terminal and the case 10 such that the bias of the insertion stress of the connector 193 does not occur. Also, since it is possible to suppress the height direction and the width direction of the connector 193 from being extremely lengthened, the deformation of the connector 193 can be reduced, and the bias of the insertion stress of the connector 193 can be reduced. Also, since the height direction and the width direction of the connector 193 are suppressed from being extremely lengthened, a distance between the respective connector fixing portions 10f to 10m can be shortened. Therefore, the resonance frequencies of the connector 193 and the case 10 can be made higher than the frequency of vibration transmitted from the engine and the like, leading to an improvement in the vibration resistance of the vehicle.

Also, in the present embodiment, the AC terminal 822b is arranged closer to the other side of the longitudinal-direction side of the case 10 than the AC terminals 822a and 822c. Due to such arrangement, the first support member 820 and the first wall 10d form an inverted triangle having a gentle angle. Therefore, since the height directions and the width directions of the AC connector 188 and the connector 193 are suppressed from being extremely lengthened, it is possible to obtain the operational effect that improves the connection reliability and the vibration resistance.

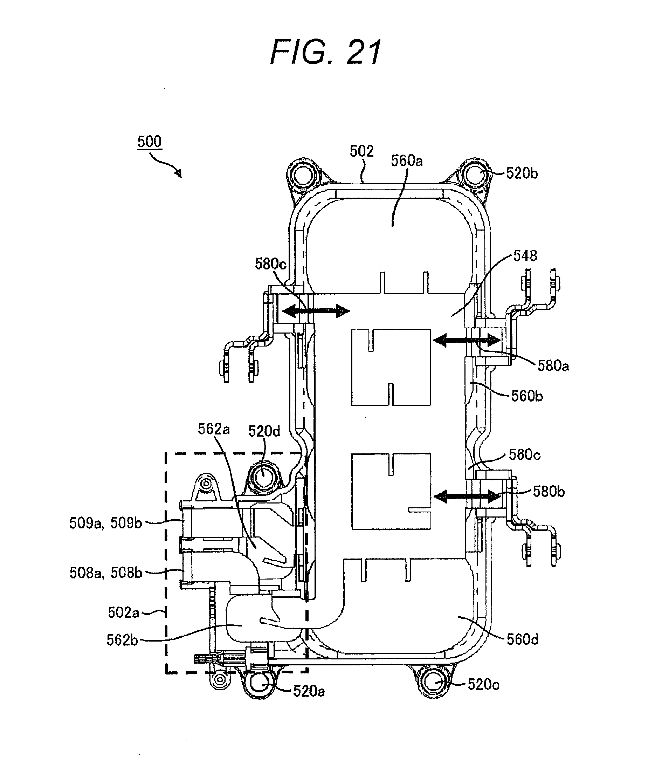

FIG. 21 is a top view of the capacitor module 500 from which a resin sealing material 550 is removed.

The capacitor case 502 receives capacitor elements 560a to 560d, a negative electrode-side busbar 548, a positive electrode-side busbar, which is not illustrated, and capacitor elements 562a to 562b for noise removal.

The capacitor elements 560a to 560d are cylindrical film capacitors. The capacitor elements 560a to 560d smooth the DC current and output the smoothed DC current to the power semiconductor modules 300a to 300c. Electrodes of one side of the capacitor elements 560a to 560d are arranged to face the bottom of the capacitor case 502, and electrodes of the other side are arranged to face the opening side of the capacitor case 502. Also, the capacitor elements 560a to 560d are arranged in parallel along the long side of the capacitor case 502.

The negative electrode-side busbar 548 is connected to the electrodes of the other side of the capacitor elements 560a to 560d. The positive terminal-side busbar, which is not illustrated, is arranged between the bottom surface of the capacitor case 502 and the capacitor elements 560a to 560d, and is connected to the electrodes of the other side of the capacitor elements 560a to 560d.

The capacitor elements 562a to 562b for noise removal are cylindrical film capacitors, and are small-sized capacitor elements having an electrostatic capacity smaller than the capacitor elements 560a to 560d. One electrode of the capacitor element 562a for noise removal is connected to the positive electrode-side busbar, which is not illustrated. The other electrode of the capacitor element 562a for noise removal is electrically connected to the ground of the vehicle body via the metal case 10. One electrode of the capacitor element 562b for noise removal is connected to the negative electrode-side busbar 548. The other electrode of the capacitor element 562b for noise removal is electrically connected to the ground of the vehicle body via the metal case 10. The capacitor elements 562a to 562b for noise removal are capacitor elements for removing electromagnetic noise propagated via the DC terminals 900a to 900b generated by the driving of the motor MG1 or the like of FIG. 2.

The capacitor elements 562a to 562b for noise removal are arranged inside the protruding containing portion 502a protruding from the wall of one side of the capacitor case 502. On the other hand, the power source terminals 508a to 508b and 509a to 509b protrude from the protruding containing portion 502a. The capacitor elements 560a to 560d are electrically connected to the power source terminals 508a to 508b and the power source terminals 509a to 509b via the capacitor elements 562a and 562b for noise removal.

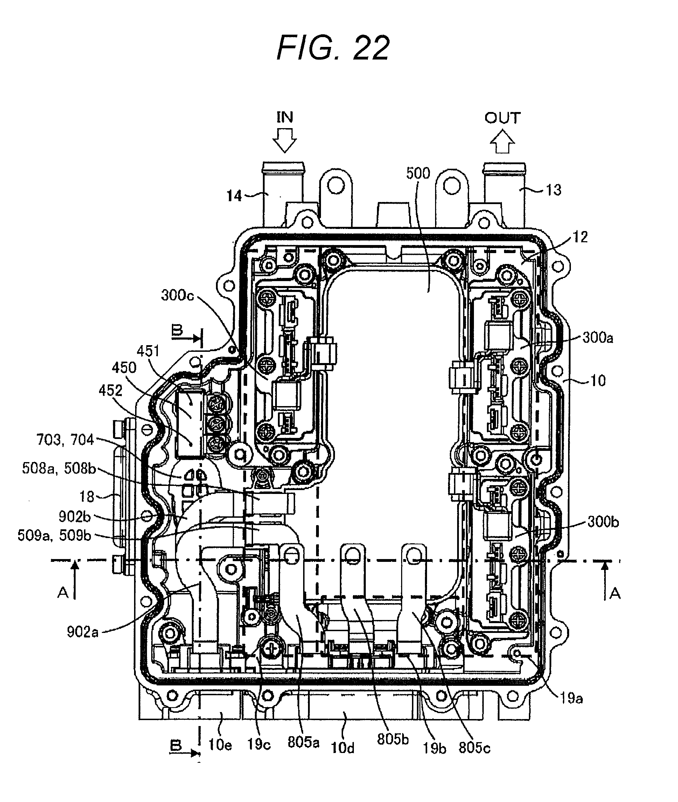

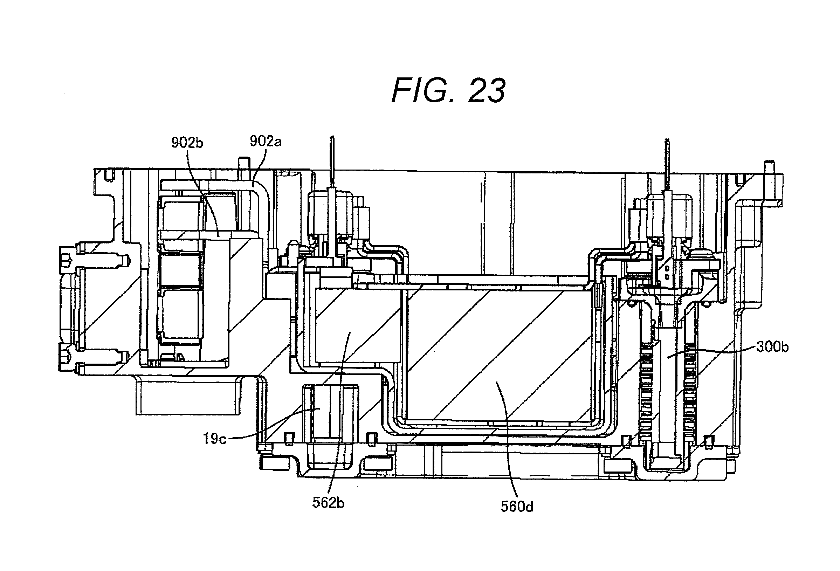

FIG. 22 is a top view of the power conversion apparatus 200 from which electric parts arranged above the capacitor module 500 illustrated in FIG. 4 are removed. FIG. 23 is a sectional view seen from the direction of the arrows of dashed line AA of FIG. 22.

The power semiconductor module 300a and the power semiconductor module 300b are arranged in parallel along a flow direction of a cooling refrigerant flowing through the first channel portion 19a indicated by dashed line, and is fixed to the channel forming body 12. The power semiconductor module 300c is arranged near the outlet piping as the third channel portion 19c indicated by dashed line, and is fixed to the channel forming body 12. Also, the power semiconductor module 300c is arranged at a position facing the power semiconductor module 300a via the capacitor module 500.

The capacitor elements 562a to 562b for noise removal, which are illustrated in FIG. 21, are arranged at positions facing the power semiconductor module 300b via the capacitor module 500. Also, as illustrated in FIG. 23, the capacitor elements 562a to 562b for noise removal are arranged above the third channel portion 19c and are thermally connected to the third channel portion 19c.

The power source terminals 508a to 508b and 509a to 509b provided in the capacitor module 500 are connected to the DC busbars 902a and 902b. As described and illustrated in FIG. 18, the DC busbars 902a and 902b are connected to the DC terminals 900a and 900b.

Due to such arrangement relationship, the capacitor elements 562a to 562b for noise removal do not receive heat from the power semiconductor modules 300a to 300c, and the electric parts inside the power conversion apparatus 200 is further integrated. Thus, the power conversion apparatus can be downsized. That is, the capacitor elements 562a to 562b for noise removal are thermally connected to the power semiconductor modules 300a and 300b via the capacitor module 500, the first channel portion 19a, and the third channel portion 19c. Furthermore, the capacitor elements 562a to 562b for noise removal are thermally connected to the power semiconductor module 300c via the third channel portion 19c. Therefore, the capacitor elements 562a to 562b for noise removal can be thermally greatly separated from two of the three power semiconductor modules 300a to 300c. The power semiconductor module 300c arranged at a thermally close position also passes through the third channel portion 19c through which the refrigerant flows. Therefore, it is less susceptible to heat from the power semiconductor modules 300a to 300c.

Also, the refrigerant flowing through the refrigerant channel 19 flows in order of the vicinity of the power semiconductor module 300c, the downward of the capacitor elements 562a to 562b for noise removal, the vicinity of the power semiconductor module 300b, and the vicinity of the power semiconductor module 300a. Therefore, since the capacitor elements 562a to 562b for noise removal are cooled by the refrigerant in which only heat received from the power semiconductor module 300c has been accumulated, it is less susceptible to heat from the power semiconductor modules 300a and 300b.

Furthermore, since the capacitor elements for noise removal are vulnerable to heat, it is necessary to prevent the influence of heat from the outside as well as the cooling of self-heating. That is, it is necessary to prevent the influence of heat transmitted from the outside of the power conversion apparatus 200 via the DC busbars 902a and 902b. Therefore, in the present embodiment, since the third channel portion 19c is formed just below the capacitor elements 562a to 562b for noise removal, the capacitor elements 562a to 562b for noise removal and the third channel portion 19c are thermally closely connected to each other. Therefore, the self-heating of the capacitor elements 562a to 562b for noise removal and the heat from the outside can be sufficiently transmitted to the refrigerant.

Also, in the present embodiment, although the electric parts arranged near the third channel portion 19c are the capacitor elements for noise removal, the resistor 450 may also be arranged. That is, since the electric circuit parts required to prevent the influence of heat transmitted from the outside of the power conversion apparatus 200 via the DC busbars 902a and 902b are arranged near the third channel portion 19c, they may be electric circuit parts electrically connected in series or parallel to the capacitor element 560d and the DC terminals 902a and 902b.

The DC busbars 902a and 902b form a deviation on a principal surface in the vicinity of the power terminals 508a to 508b and 509a to 509b side provided in the capacitor module 500. On the other hand, the DC busbar 902a is arranged above the DC busbar 902b. Therefore, in the vicinity of the DC terminals 900a and 900b, the principal surfaces of DC busbar 902a and 902b are overlapped. Therefore, the wiring inductance of the DC busbars 902a and 902b is reduced.

Also, the DC terminals 900a and 900b illustrated in FIG. 18 are arranged at positions closer to the capacitor elements 562a and 562b for noise removal than the first power semiconductor modules 300a to 300c. Therefore, the wiring distance of the DC busbars 902a and 902b arranged inside the case 10 can be shortened. For this reason, electromagnetic noise emitted from the DC busbars 902a and 902b can be reduced. Also, electromagnetic noise transmitting the DC busbars 902 and 902b can be removed by the capacitor elements 562a and 562b for noise removal before transmission to the negative electrode-side busbar 548, the positive electrode-side busbar, or the capacitor element 560a, and the like within the capacitor module 500.

Also, as illustrated in FIG. 21, back-flow currents 580a to 580c flowing between the upper and lower arms when the IGBTs inside the first power semiconductor modules 300a to 300c are switched flow through the negative electrode-side busbar 548 and the positive electrode-side busbar. In the present embodiment, the wiring distance of the capacitor elements 562a and 562b for noise removal and the IGBTs or diodes inside the first power semiconductor modules 300a to 300c is smaller than the wiring distance of the capacitor elements 562a and 562b for noise removal and the DC terminals 900a and 900b. Therefore, since the back-flow currents 580a to 580c flow through the capacitor elements 562a and 562b for noise removal, the capacitor elements 562a and 562b for noise removal suppress are suppressed from performing an insufficient noise removal function.

Also, the capacitor elements 562a and 562b for noise removal may be arranged outside the capacitor case 502 and fixed to the channel forming body 12. In the present embodiment, since the capacitor elements 560a to 560d and the capacitor elements 562a and 562b for noise removal are film capacitors, and use members having similar heat conduction, the capacitor elements 560a to 560d and the capacitor elements 562a and 562b for noise removal are encapsulated by a resin encapsulating material 550 within the single capacitor case 502. Therefore, the increase of connection points for the electrical connection of the capacitor elements 562a and 562b for noise removal is suppressed, and it is easy to manage temperature management within the power conversion apparatus 200.

The resistor 450 functions as a discharging resistor that converts charges remaining in the capacitor elements 560a to 560d into heat energy, preventing electric shock during repair work. Therefore, in particular, the resistor 450 is required to be thermally blocked from other electric parts. Hence, the resistor 450 is arranged at a side opposite to the capacitor module 500 via the channel portion 19c. Also, the resistor 450 is provided with the positive electrode-side terminal 451 and the negative electrode-side terminal 452 on one side. The positive electrode-side terminal 451 is connected to the driver circuit board 22 via harness which is not illustrated. On the driver circuit board 22, the switching element electrically connected in series to the resistor 450 is mounted. On the other hand, the negative electrode-side terminal 452 is connected to the power terminal 509a being the negative electrode side. The switching operation of the switching element mounted on the driver circuit board 22 is controlled by a micom or the like mounted on the driver circuit board 22 or the control circuit board 20.

Also, on the bottom of the case 10, the opening 703 penetrating through the terminal 702 extending from the DC/DC converter 700 illustrated in FIG. 4 is formed. In FIG. 22, the opening 703 is closed by the cover 704. The cover 704 is used when the power conversion apparatus 200 is not used in combination with the DC/DC converter 700 in use. When the power conversion apparatus 200 and the DC/DC converter 700 are used in combination as illustrated in FIG. 4, the corresponding cover 704 is removed. Therefore, the power conversion apparatus 200 of the present embodiment is configured to be attachable or detachable to the DC/DC converter 700 according to the embodiment of the vehicle.

Also, a radio-frequency noise current flows through the AC busbars 805a to 805c during the switching operation of the IGBTs inside the power semiconductor module. The noise current is generated in a concentric shape, centered on the direction of the flow of the current to the radio-frequency magnetic field. The noise is generated by the interlinkage of the radio-frequency magnetic field with the control circuit board 20. Therefore, in the present embodiment, the direction of forming the DC busbars 902a and 900b directed from the DC terminals 900a and 900b toward the inside of the case 10 is formed along the direction of forming the AC busbars 805a to 805c directed from the AC terminals 822a to 822c illustrated in FIG. 17 toward the inside of the case 10. Since the direction of the current flowing through the AC busbars 805a to 805c is opposite to the direction of the current flowing through the DC busbars 902a and 900b, the magnetic field generated by the current flowing through the AC busbars 805a to 805c and the magnetic field generated by the current flowing through the DC busbars 902a and 900b are consumed within the case 10 to suppress the magnetic field generated by the current flowing through the AC busbars 805a to 805c and the DC busbars 902a and 900b.

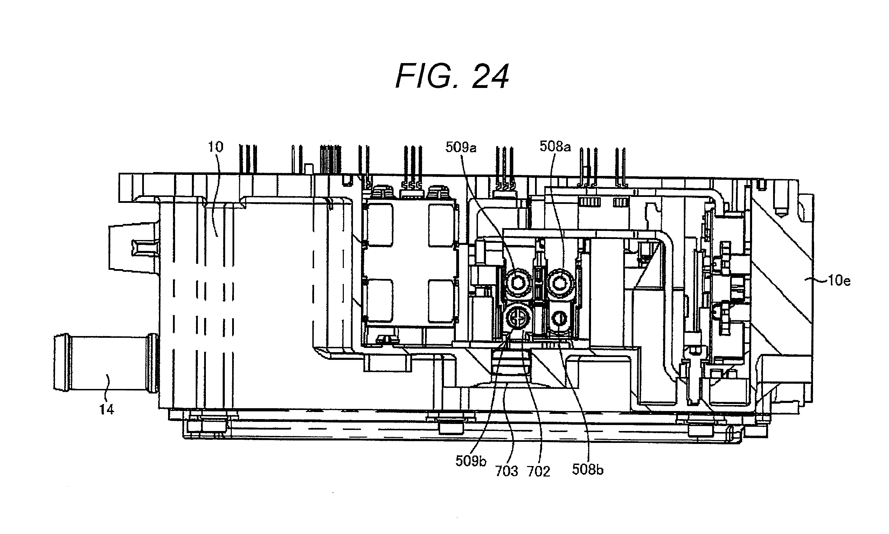

FIG. 24 is a sectional view seen from the direction of the arrows of dashed line BB of FIG. 22.

The terminal 702 of the DC/DC converter 700 passes through the opening 703 and is connected to the power terminal 509b provided in the capacitor module 500. In the present embodiment, the DC/DC converter 700 functions as a step-down circuit for charging power to drive 12-V electric components of the vehicle. However, when malfunction occurs in the power conversion apparatus 200 or the like and thus it is difficult to supply power to the driving motor, emergency power can be supplied from the DC/DC converter 700.

The power terminals 508a and 509a provided in the capacitor module 500 are arranged to face the window 17 provided in the case 10. In this manner, the connection workability of the power terminals 508a and 509a is improved. Furthermore, the power terminals 508b and 509b being portions connected with the DC/DC converter 700 are also arranged to face the window 17. In this manner, the connection workability of the power terminals 508b and 509b is also improved.

The contents of the disclosure of this application based on the priority are incorporated herein by reference. Japanese Patent Application No. 2010-289096 (filed on December 27, 2010).

## Claims

1. A vehicular power conversion apparatus comprising:
a capacitor circuit unit configured to smooth a DC current supplied from a DC power source;
a channel forming body configured to form a channel through which a cooling refrigerant flows;
a power semiconductor module having a power semiconductor element configured to convert a DC current output from the capacitor circuit unit into an AC current and supply the AC current to a vehicle driving motor;
a housing configured to contain the capacitor circuit unit, the channel forming body, and the power semiconductor module;
a DC terminal provided on a surface of the housing; and
an electric circuit element electrically connected in series or in parallel with regard to the capacitor circuit unit and the DC terminal,
wherein the channel forming body forms a first channel and a second channel,
the first channel and the second channel are arranged in parallel with each other while interposing the capacitor circuit unit,
the power semiconductor module has a first power semiconductor module configured to output a first-phase AC current, a second power semiconductor module configured to output a second-phase AC current, and a third power semiconductor module configured to output a third-phase AC current,
the first power semiconductor module and the second power semiconductor module are fixed in parallel to the first channel along a flow direction of a cooling refrigerant flowing through the first channel,
the third power semiconductor module is fixed to the second channel such that the first power semiconductor module and the third power semiconductor module face each other via the capacitor circuit unit, and
the electric circuit element is arranged in such a position that the second power semiconductor module and the electric circuit element face each other via the capacitor circuit unit.

2. The vehicular power conversion apparatus according to claim 1, wherein the electric circuit element is a noise removing capacitor element having an electrode on one side electrically connected to the DC terminal and an electrode on the other side electrically connected to ground of a vehicle body.

3. The vehicular power conversion apparatus according to claim 2, wherein the DC terminal is arranged in a position closer to the noise removing capacitor element than the first power semiconductor module, the second power semiconductor module, and the third power semiconductor module.

4. The vehicular power conversion apparatus according to claim 2, further comprising:
a capacitor case containing the capacitor circuit unit and the noise removing capacitor element; and
a resin sealing material sealing the capacitor circuit unit and the noise removing capacitor element in the capacitor case,
wherein the capacitor circuit unit and the noise removing capacitor element are film capacitors.

5. The vehicular power conversion apparatus according to claim 1, further comprising a discharging resistor electrically connected to the capacitor circuit unit, wherein
the discharging resistor is arranged on an opposite side to the capacitor circuit unit via the second channel.

6. The vehicular power conversion apparatus according to claim 1, wherein the capacitor circuit unit has a first DC terminal connected to the DC terminal via wiring,
the housing has an opening formed at a part facing the first DC terminal, and
the opening of the housing is covered by a cover.

7. The vehicular power conversion apparatus according to any one of claims 1 to 6, further comprising:
a DC busbar configured to supply the DC current to the power semiconductor module;
an AC busbar configured to supply the AC current to the driving motor; and
an AC terminal provided on the surface of the housing, on which the DC terminal is provided,
wherein a formation direction of the DC busbar towards an interior of the housing from the DC terminal is formed along a formation direction of the AC busbar towards an interior of the case from the AC terminal.
